# EUROPEAN PATENT APPLICATION

(11) **EP 4 807 997 A1**
(43) Date of publication of application: **16.09.2026**
(21) Application number: 24907981.5
(22) Date of filing: 16.12.2024
(51) Int. Cl.: H03M 13/11, H03M 13/27, H03M 13/00

(54) **METHOD AND APPARATUS FOR DECODING DATA**

(30) Priority: 18.12.2023 KR 20230184797
(71) Applicant: Samsung Electronics Co., Ltd., Suwon-si, Gyeonggi-do 16677 (KR)
(72) Inventor: JANG, Min, Suwon-si, Gyeonggi-do 16677 (KR); MYUNG, Seho, Suwon-si, Gyeonggi-do 16677 (KR); LEE, Hyunjae, Suwon-si, Gyeonggi-do 16677 (KR); LIM, Hyuntack, Suwon-si, Gyeonggi-do 16677 (KR)
(74) Representative: Gulde & Partner
(86) International application number: PCT/KR2024/020411
(87) International publication number: WO 2025/135698

(57) **Abstract**

The present disclosure relates to a 5G or 6G communication system for supporting a higher data transmission rate than a 4G communication system such as LTE. The present disclosure can be applied to intelligent services (for example, smart homes, smart buildings, smart cities, smart cars or connected cars, health care, digital education, retail businesses, security- and safety-related services, and the like) on the basis of 5G communication technology and IoT-related technology. A method performed by a receiver, according to an embodiment of the present disclosure, may comprise the steps of: acquiring an original input sequence on the basis of a received signal; acquiring P candidate input sequences on the basis of the original input sequence, P being 2 or more, and each of the P candidate input sequences being obtained by changing at least one of elements included in the original input sequence to a predefined value; acquiring a single input sequence on the basis of the P candidate input sequences; and acquiring a decoding result corresponding to the received signal on the basis of an output obtained as the single input sequence is input into a single decoder.

## Description

### [Technical Field]

The disclosure generally relates to a communication or broadcasting system, and more particularly, to a method and device for decoding data in a communication or broadcasting system using a channel code.

### [Background Art]

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100µsec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collison avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable super-high-performance communication and computing resources (such as mobile edge computing (MEC), clouds, and the like) over the network. In addition, through designing new protocols to be used in 6G communication systems, developing mecahnisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

### [Disclosure of Invention]

### [Technical Problem]

Various embodiments of the disclosure may provide a method and device for decoding data in a communication or broadcasting system using a channel code.

Technical problems to be achieved in various embodiments of the disclosure are not limited to the above-described technical problems, and other technical problems that are not described may be considered by those of ordinary skill in the art from various embodiments of the disclosure to be described below.

### [Solution to Problem]

According to an embodiment, a method performed by a device may be provided.

According to an embodiment, the method may include obtaining an original input sequence based on a received signal.

According to an embodiment, the method may include obtaining P candidate input sequences based on the original input sequence.

According to an embodiment, P may be 2 or more.

According to an embodiment, each of the P candidate input sequences may be obtained by changing at least one of elements included in the original input sequence to a predefined value.

According to an embodiment, the method may include obtaining a single input sequence based on the P candidate input sequences.

According to an embodiment, the method may include obtaining a decoding result corresponding to the received signal based on an output obtained by inputting the single input sequence to a single decoder.

According to an embodiment, the single decoder may be configured to decode a low-density parity-check (LDPC) code.

According to an embodiment, a lifting size associated with the LDPC code may be configured to one of a plurality of predefined lifting sizes.

According to an embodiment, P may be determined based on the configured lifting size and a maximum lifting size among the plurality of predefined lifting sizes.

According to an embodiment, the configured lifting size may correspond to a size of each of the P candidate input sequences.

According to an embodiment, when the maximum lifting size is 384, P may be 32 when the configured lifting size is 12 or less, P may be 16 when the configured lifting size is greater than 12 and less than or equal to 24, P may be 8 when the configured lifting size is greater than 24 and less than or equal to 48, P may be 4 when the configured lifting size is greater than 48 and less than or equal to 96, and P may be 2 when the configured lifting size is greater than 96 and less than or equal to 192.

According to an embodiment, when the maximum lifting size is 192, P may be 16 when the configured lifting size is 12 or less, P may be 8 when the configured lifting size is greater than 12 and less than or equal to 24, P may be 4 when the configured lifting size is greater than 24 and less than or equal to 48, and P may be 2 when the configured lifting size is greater than 48 and less than or equal to 96.

According to an embodiment, P may be determined to satisfy $P = {2}^{log \left(\left⌊{Z}_{max}/Z\right⌋\right)}$, *Z*ₘₐₓ may be the maximum lifting size, and Z may be the configured lifting size.

According to an embodiment, the at least one modified element may include p elements selected from among elements included in the original input sequence in ascending order of absolute value.

According to an embodiment, the P candidate input sequences may be different sequences obtained by changing each of the p elements to a maximum positive number or a minimum negative number representable by the single decoder, and *P* = 2*^{p}* may be satisfied.

According to an embodiment, the output may be a single output including decoding results of the P candidate input sequences.

According to an embodiment, the decoding result corresponding to the received signal may correspond to a decoding result of one candidate input sequence identified based on a validity check on the decoding results of the P candidate input sequences included in the single output.

According to an embodiment, when the single decoder is configured to distribute elements included in the input sequence, upon input of the single input sequence to the single decoder, elements included in any one of the P candidate input sequences included in the single input sequence may be discontinuously allocated to at least one of a memory or a processing element (PE) corresponding to the single decoder within a region corresponding to the maximum lifting size.

According to an embodiment, when the single decoder is configured to continuously allocate elements included in an input sequence, upon input of the single input sequence to the single decoder, elements included in any one of the P candidate input sequences included in the single input sequence may be continuously allocated to at least one of a memory or a PE corresponding to the single decoder within a region corresponding to the configured lifting size.

According to an embodiment, the single input sequence may be obtained by concatenating the P candidate input sequences, by sequentially selecting elements from each of the P candidate input sequences and sequentially arranging the selected elements, or by interleaving of the P candidate input sequences.

According to an embodiment, a device may be provided.

According to an embodiment, the device may include a transceiver and a processor connected to the transceiver.

According to an embodiment, the processor may be configured to obtain an original input sequence based on a received signal.

According to an embodiment, the processor may be configured to obtain P candidate input sequences based on the original input sequence.

According to an embodiment, P may be 2 or more.

According to an embodiment, each of the P candidate input sequences may be obtained by changing at least one of elements included in the original input sequence to a predefined value.

According to an embodiment, the processor may be configured to obtain a single input sequence based on the P candidate input sequences.

According to an embodiment, the processor may be configured to obtain a decoding result corresponding to the received signal based on an output obtained by inputting the single input sequence to a single decoder.

According to an embodiment, the single decoder may be configured to decode a low-density parity-check (LDPC) code.

According to an embodiment, a lifting size associated with the LDPC code may be configured to one of a plurality of predefined lifting sizes.

According to an embodiment, P may be determined based on the configured lifting size and a maximum lifting size among the plurality of predefined lifting sizes.

According to an embodiment, the configured lifting size may correspond to a size of each of the P candidate input sequences.

According to an embodiment, when the maximum lifting size is 384, P may be 32 when the configured lifting size is 12 or less; P may be 16 when the configured lifting size is greater than 12 and less than or equal to 24, P may be 8 when the configured lifting size is greater than 24 and less than or equal to 48, P may be 4 when the configured lifting size is greater than 48 and less than or equal to 96, and P may be 2 when the configured lifting size is greater than 96 and less than or equal to 192.

According to an embodiment, when the maximum lifting size is 192, P may be 16 when the configured lifting size is 12 or less, P may be 8 when the configured lifting size is greater than 12 and less than or equal to 24, P may be 4 when the configured lifting size is greater than 24 and less than or equal to 48, and P may be 2 when the configured lifting size is greater than 48 and less than or equal to 96.

According to an embodiment, P may be determined to satisfy $P = {2}^{log \left(\left⌊{Z}_{max}/Z\right⌋\right)}$, *Z*ₘₐₓ may be the maximum lifting size, and *Z* may be the configured lifting size.

According to an embodiment, the at least one modified element may include p elements selected from among elements included in the original input sequence in ascending order of absolute value.

According to an embodiment, the P candidate input sequences may be different sequences obtained by changing each of the p elements to a maximum positive number or a minimum negative number representable by the single decoder, and *P* = 2*^{p}* may be satisfied.

According to an embodiment, the output may be a single output including the decoding results of the P candidate input sequences.

According to an embodiment, the decoding result corresponding to a received signal may correspond to the decoding result of one candidate input sequence identified based on a validity check on decoding results of the P candidate input sequences included in the single output.

According to an embodiment, when the single decoder is configured to distribute elements included in the input sequence, upon input of the single input sequence to the single decoder, elements included in any one of the P candidate input sequences included in the single input sequence may be discontinuously allocated to at least one of a memory or a processing element (PE) corresponding to the single decoder within a region corresponding to the maximum lifting size.

According to an embodiment, when the single decoder is configured to continuously allocate elements included in an input sequence, upon input of the single input sequence to the single decoder, elements included in any one of the P candidate input sequences included in the single input sequence may be continuously allocated to at least one of a memory or a PE corresponding to the single decoder within a region corresponding to the configured lifting size.

According to an embodiment, the single input sequence may be obtained by concatenating the P candidate input sequences, by sequentially selecting elements from each of the P candidate input sequences and sequentially arranging the selected elements, or by interleaving of the P candidate input sequences.

Various embodiments of the disclosure described above are merely some of preferred embodiments of the disclosure, and various embodiments reflecting the technical features of the various embodiments of the disclosure may be derived and understood by those skilled in the art based on the detailed description to be described below.

### [Advantageous Effects of Invention]

According to various embodiments of the disclosure, the efficiency of a decoder for an LDPC code can be effectively improved.

Effects that may be obtained from the disclosure are not limited to the above-described effects, and other effects that are not described will be clearly understood by those of ordinary skill in the art to which the disclosure belongs from the description below.

### [Brief Description of Drawings]

FIG. 1 illustrates a wireless communication system to which various embodiments of the disclosure are applicable.
FIG. 2 illustrates an example of a constitution of a device performing communication in a wireless communication system to which various embodiments of the disclosure are applicable.
FIG. 3 illustrates an example of a parity-check matrix of an LDPC code to which various embodiments of the disclosure are applicable.
FIG. 4 illustrates an example of a binary graph corresponding to a parity-check matrix to which various embodiments of the disclosure are applicable.
FIG. 5 is a block diagram illustrating a transmitting device according to various embodiments of the disclosure.
FIG. 6 is a block diagram illustrating a receiving device according to various embodiments of the disclosure.
FIG. 7 illustrates an example of an ensemble decoding procedure to which various embodiments of the disclosure are applicable.
FIG. 8 is a block diagram illustrating an example of an operation sequence of ensemble decoding to which various embodiments of the disclosure are applicable.
FIG. 9 illustrates an example of a process for constructing a QC-LDPC code to which various embodiments of the disclosure are applicable.
FIG. 10 illustrates an example of a constitution of a reconfigurable LDPC code decoder to which various embodiments of the disclosure are applicable.
FIG. 11 illustrates an example of an operation in which a reconfigurable LDPC code decoder, to which various embodiments of the disclosure are applicable, decodes an LDPC code having a lifting size smaller than a maximum lifting size.
FIG. 12 illustrates an example of an invalid component when a reconfigurable LDPC code decoder, to which various embodiments of the disclosure are applicable, decodes an LDPC code having a lifting size smaller than a maximum lifting size.
FIG. 13 illustrates an example in which a reconfigurable LDPC code decoder decodes inputs for at least two LDPC codes having a lifting size smaller than a maximum lifting size according to an ensemble decoding method, according to various embodiments of the disclosure.
FIG. 14 illustrates an example of an operation of a reconfigurable LDPC code decoder implemented based on an extended barrel shifter (EBS), to which various embodiments of the disclosure are applicable.
FIG. 15 illustrates an example in which an ensemble decoding method according to various embodiments of the disclosure is applied based on an operation of a reconfigurable LDPC code decoder implemented based on an EBS.
FIG. 16 illustrates an example of an operation of a reconfigurable LDPC code decoder implemented based on a QC-LDPC shifter network (QSN), to which various embodiments of the disclosure are applicable.
FIG. 17 illustrates an example in which an ensemble decoding method according to various embodiments of the disclosure is applied based on an operation of a reconfigurable LDPC code decoder implemented based on a QSN.
FIG. 18 is a conceptual diagram illustrating operations according to various embodiments of the disclosure.
FIG. 19 is a flowchart illustrating an example of an operation of a device according to various embodiments of the disclosure.

### [Mode for the Invention]

Hereinafter, embodiments of the disclosure will be described in detail together with the accompanying drawings.

In describing the embodiments, descriptions of technical contents that are well known in the technical field to which the disclosure pertains and that are not directly related to the disclosure will be omitted. This is to more clearly convey the gist of the disclosure without obscuring the gist of the disclosure by omitting unnecessary description.

For the same reason, some components are exaggerated, omitted, or schematically illustrated in the accompanying drawings. Further, the size of each component does not fully reflect the actual size. In each drawing, the same reference numerals are given to the same or corresponding components.

Advantages and features of the disclosure, and a method of achieving them will become apparent with reference to the embodiments described below in detail in conjunction with the accompanying drawings. However, the disclosure is not limited to the embodiments disclosed below, but may be implemented in various different forms, and only embodiments of the disclosure enable the disclosure to be complete, and are provided to fully inform the scope of the disclosure to those of ordinary skill in the art to which the disclosure belongs, and the disclosure is only defined by the scope of the claims. Like reference numerals refer to like components throughout the specification.

In this case, it will be understood that each block of flowcharts and combinations of the flowcharts may be performed by computer program instructions. Because these computer program instructions may be mounted in a processor of a general purpose computer, special purpose computer, or other programmable data processing equipment, the instructions performed by a processor of a computer or other programmable data processing equipment generate a means that performs functions described in the flowchart block(s). Because these computer program instructions may be stored in a computer usable or computer readable memory that may direct a computer or other programmable data processing equipment in order to implement a function in a particular manner, the instructions stored in the computer usable or computer readable memory may produce a production article including instruction means for performing the function described in the flowchart block(s). Because the computer program instructions may be mounted on a computer or other programmable data processing equipment, a series of operation steps are performed on the computer or other programmable data processing equipment to generate a computer-executable process; thus, instructions for performing the computer or other programmable data processing equipment may provide steps for performing functions described in the flowchart block(s).

Further, each block may represent a portion of a module, a segment, or a code including one or more executable instructions for executing a specified logical function(s). Further, it should be noted that in some alternative implementations, functions recited in the blocks may occur out of order. For example, two blocks illustrated one after another may in fact be performed substantially simultaneously, or the blocks may be sometimes performed in the reverse order according to the corresponding function.

In this case, the term '-unit' used in this embodiment means software or hardware components such as a field programmable gate array (FPGA) or an application specific integrated circuit (ASIC), and '-unit' performs certain roles. However, '-unit' is not limited to software or hardware. '-unit' may be formed to reside in an addressable storage medium or may be formed to reproduce one or more processors. Therefore, as an example, '-unit' includes components such as software components, object-oriented software components, class components, and task components, processes, functions, properties, procedures, subroutines, segments of program code, drivers, firmware, microcode, circuit, data, databases, data structures, tables, arrays, and variables. Functions provided in the components and '-units' may be combined into a smaller number of components and '-units' or may be further separated into additional components and '-units'. Further, components and '-units' may be implemented to reproduce one or more CPUs in a device or secure multimedia card.

Hereinafter, various embodiments will be described in detail with reference to the accompanying drawings. In this case, it should be noted that in the accompanying drawings, the same components are denoted by the same reference numerals as much as possible. Further, it should be noted that the accompanying drawings are provided to help the understanding of the disclosure, and are not limited to the form or disposition illustrated in the drawings of the disclosure. Further, detailed descriptions of well-known functions and constitutions that may obscure the gist of the disclosure will be omitted. In the following description, only parts necessary for understanding an operation according to various embodiments of the disclosure are described, and it should be noted that descriptions of other parts will be omitted so as not to obscure the gist of the disclosure.

Various embodiments of the disclosure relate to a method and device for effectively decoding data in a communication and broadcasting system using a low-density parity-check (LDPC) code that gradually updates a posterior probability or an equivalent metric for a codeword bit through an iterative decoding operation.

Various embodiments of the disclosure relate to a constitution of an ensemble decoding architecture for LDPC codes in a communication and broadcasting system.

In general, when data is transmitted and received between a transmitter and a receiver in a communication and broadcasting system, performance of a link may be significantly degraded by various types of noise, fading, and inter-symbol interference (ISI) present in a communication channel. Therefore, in order to implement high-speed digital communication or broadcasting systems requiring high data throughput and reliability, such as next-generation mobile communication, digital broadcasting, and mobile Internet, there is a need to develop techniques for overcoming noise, fading, and inter-symbol interference.

As such, error detection codes and error correcting codes (ECC) are used to allow a receiver to overcome errors that may occur due to a communication channel. Error correction codes used in communication between a transmitter and the receiver are generally referred to as channel coding or forward error correction (FEC). The transmitter encodes an information vector to be transmitted to generate a codeword vector and transmits the codeword vector, and the receiver performs a series of processes on a received signal and decodes the received signal to estimate the information vector.

Various channel coding techniques are used in a communication and broadcasting system. For example, channel coding methods may include a convolutional code, a turbo code, a low-density parity-check (LDPC) code, and a polar code. A turbo code and an LDPC code are channel coding techniques that perform iterative decoding, and exhibit particularly excellent performance when a length of an information vector is large, and thus are used in various communication and broadcasting systems.

An LDPC code is also a channel coding technique known to achieve performance close to channel capacity with a decoding algorithm of practical complexity. In particular, decoding referred to as belief-propagation (BP) is suitable for parallelizing individual operations and is advantageous in achieving high throughput. Due to these advantages, LDPC codes are used in various communication and broadcasting systems, such as IEEE 802.11n/ad Wi-Fi, DVB-T2/C2/S2, and ATSC 3.0, and are also adopted and used in a 3GPP new radio (NR) system, which is a 5G mobile communication system.

Various embodiments of the disclosure may improve decoding performance of a low-density parity-check (LDPC) code in a communication or broadcasting system. In general, a channel code exhibits low error-correction performance when a code dimension (i.e., the number of information bits to be encoded, which is an input length of an encoder) and a code length (i.e., the number of codeword bits obtained by encoding, which is an output length of the encoder) are small. For example, even at a same code rate (i.e., a ratio of the code dimension to the code length), error-correction performance when the code dimension and the code length are small is lower than that when the code dimension and the code length are large. Further, LDPC codes exhibit more significant performance degradation when the code dimension and the code length are small. The disclosure may improve error-correction performance without increasing additional hardware cost, complexity, or latency by providing a method and device for efficiently performing decoding based on a decoder structure and architecture.

Hereinafter, an embodiment of the disclosure is described using a 5G system as an example, but the embodiment of the disclosure may also be applied to other communication systems having a similar technical background or channel type. For example, LTE or LTE-A mobile communications and mobile communication technologies developed after 5G, may be included therein. Accordingly, the embodiments of the disclosure may be applied to other communication systems through some modification without significantly departing from the scope of the disclosure by determination of a person skilled in the art.

Further, in describing the disclosure, in the case that it is determined that a detailed description of a related function or constitution may unnecessarily obscure the gist of the disclosure, a detailed description thereof will be omitted. Terms described below are terms defined in consideration of functions in the disclosure, which may vary according to intentions or customs of users and operators. Therefore, the definition should be made based on the content throughout this specification.

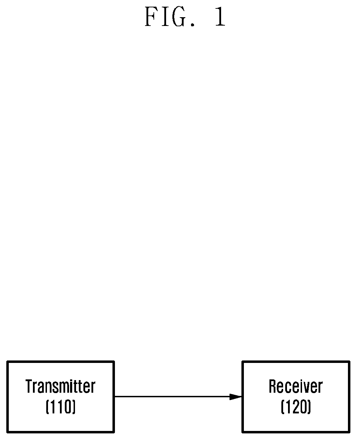

FIG. 1 illustrates a wireless communication system to which various embodiments of the disclosure are applicable.

FIG. 1 illustrates a transmitter 110 and a receiver 120 as part of devices or nodes using a wireless channel in a wireless communication system. Although FIG. 1 illustrates one transmitter 110 and one receiver 120, a plurality of transmitters or a plurality of receivers may be included. Further, for convenience of description, in the disclosure, the transmitter 110 and the receiver 120 are described as separate entities, but functions of the transmitter 110 and the receiver 120 may be interchangeable. For example, in the case of an uplink of a cellular communication system, the transmitter 110 may be a terminal, and the receiver 120 may be a base station. In the case of a downlink thereof, the transmitter 110 may be a base station, and the receiver 120 may be a terminal.

In various embodiments, the transmitter 110 may generate a codeword by encoding information bits based on a turbo code, and the receiver 120 may decode a signal of the received codeword based on the turbo code. For example, the receiver 120 may decode a signal of the received codeword using a turbo decoding method and determine whether a decoding result is valid by performing a check using a concatenated cyclic redundancy check (CRC) code. The transmitter 110 and the receiver 120 perform encoding and decoding using a structure of the turbo code (e.g., trellis, linear feedback shift register, and the like) known to both the transmitter 110 and the receiver 120. For example, the structure of the turbo code may include a trellis, a linear feedback shift register, and the like defined in a 3rd generation partnership project (3GPP) long-term evolution (LTE) standard.

In various embodiments, the transmitter 110 may generate a codeword by encoding information bits based on an LDPC code, and the receiver 120 may decode a signal of the received codeword based on the LDPC code. For example, the receiver 120 may use an LDPC decoding method according to the disclosure and determine whether a decoding result is valid by performing a syndrome check. The transmitter 110 and the receiver 120 may perform LDPC encoding and decoding using a parity-check matrix known to both the transmitter 110 and the receiver 120. For example, the parity-check matrix may include a parity-check matrix defined in a 3GPP NR standard.

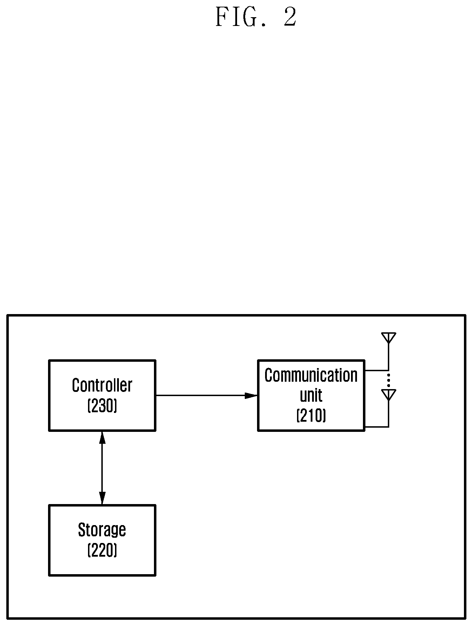

FIG. 2 illustrates an example of a constitution of a device that performs communication in a wireless communication system according to various embodiments of the disclosure.

The constitution illustrated in FIG. 2 may be understood as the constitution of a transmitter 110 or a receiver 120. Terms such as '... unit' and '... device' used hereinafter refer to a unit that processes at least one function or operation, which may be implemented into hardware, software, or a combination of hardware and software.

With reference to FIG. 2, the device may include a communication unit 210, a storage 220, and a controller 230.

The communication unit 210 may perform functions for transmitting and receiving signals through a wireless channel. For example, the communication unit 210 may perform a conversion function between a baseband signal and a bit sequence according to the physical layer standard of the system. For example, when transmitting data, the communication unit 210 may encode and modulate a transmission bit sequence to generate complex symbols. Further, when receiving data, the communication unit 210 may demodulate and decode a baseband signal to restore a received bit sequence. Further, the communication unit 210 may up-convert a baseband signal into a radio frequency (RF) band signal and transmit the RF band signal through an antenna, and down-convert the RF band signal received through the antenna into a baseband signal.

To this end, the communication unit 210 may include a transmission filter, a reception filter, an amplifier, a mixer, an oscillator, a digital to analog convertor (DAC), an analog to digital convertor (ADC), and the like. Further, the communication unit 210 may include a plurality of transmission and reception paths. Furthermore, the communication unit 210 may include at least one antenna array composed of a plurality of antenna elements. In terms of hardware, the communication unit 210 may include a digital unit and an analog unit, and the analog unit may include a plurality of sub-units according to operating power, operating frequency, and the like. Further, the communication unit 210 may include a decoding unit in order to perform decoding according to various embodiments of the disclosure.

The communication unit 210 transmits and receives signals, as described above. Accordingly, the communication unit 210 may be referred to as a 'transmitter', a 'receiver', or a 'transceiver'. Further, in the following description, transmission and reception performed through a wireless channel is used to include processing performed by the communication unit 210, as described above. Further, if the device of FIG. 2 is a base station, the communication unit 210 may further include a backhaul communication unit for communication with other network entities connected via a backhaul network.

The storage 220 may store data such as basic programs, application programs, and configuration information for the operation of the receiver 120. The storage 220 may include a volatile memory, a non-volatile memory, or a combination of a volatile memory and a non-volatile memory. The storage 220 may provide stored data according to a request from the controller 230.

The controller 230 may control the overall operations of the device. For example, the controller 230 may transmit and receive signals through the communication unit 220. Further, the controller 230 may write or read data to or from the storage 230. To this end, the controller 230 may include at least one processor or microprocessor, or be part of a processor. According to various embodiments, the controller 230 may control the device to perform operations according to various embodiments described below.

The disclosure describes various embodiments using terms used in some communication standards (e.g., 3GPP). However, this is merely illustrative. Various embodiments of the disclosure may be easily modified and applied to other communication and broadcasting systems.

In the detailed description of the disclosure, commonly used mathematical symbols may be employed to clearly express meanings thereof. Such mathematical symbols will be clearly understood by those skilled in the art to which the disclosure pertains. For example, the following commonly known mathematical symbols may be used in the detailed description of the disclosure.
- Calligraphic characters (e.g., 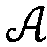 ) are used to denote sets.
- Throughout the disclosure, unless otherwise specified, it is assumed that an index of a first element of a set, a sequence, or a vector starts from 0 (zero-based numbering).
- For a set 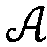 *=* 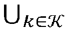 {*aₖ*} of indexed elements, 〈 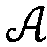 〉 represents a set 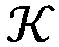 of indices of elements. For example, for 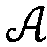 = {*a*₃,*a*₄,*a*₇,*a*₈}, 〈 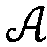 〉 = {3,4,7,8}.
- For two sets 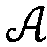 and 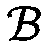 , 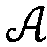 \ 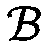 denotes the relative complement of set 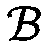 in set 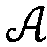 *.*
- For a set 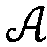 and an arbitrary number *b, b +* 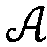 denotes the set {*a* + *b* | *a* ∈ 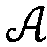 } of values obtained by adding b to each element of *A.*
- Symbols 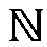 , 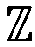 , and 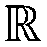 are used to denote the set of natural numbers, the set of integers, and the set of real numbers, respectively.
- ${F}_{2} = \left\{0, 1\right\}$ denotes a binary field.
- For a non-negative integer *n*, ${ℤ}_{n}$ denotes the set of n consecutive integers from 0 to *n -* 1. That is, ${ℤ}_{n} = \left\{0, 1,…, n-1\right\}$.
- Boldface lowercase letters (e.g., **a)** are used to denote vectors, and boldface uppercase letters (e.g., **A)** are used to denote matrices. Unless otherwise specified, vectors are column vectors.
- For a vector **a** and a matrix **A, a*^{T}*** and **A*^{T}*** denote their transposes, respectively.
- For a matrix **A** and two non-negative integers i and *j*, (**A**)*_{i,j}* denotes an element in the i-th row and the j-th column of the matrix **A.**
- For a matrix **A** and two sets 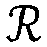 and *C* of non-negative integers, 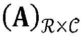 denotes a submatrix of the matrix **A** consisting of rows indexed by elements of the set 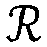 and columns indexed by elements of the set *C.*

Turbo codes and low-density parity-check (LDPC) codes are error-correction codes that achieve performance close to channel capacity. Due to their excellent performance and suitability for implementation, turbo codes and LDPC codes are used in various communication and broadcasting systems. Notably, turbo codes are adopted and used in 3GPP 4th-generation (4G) long-term evolution (LTE) mobile communication system standards, whereas LDPC codes are adopted and used in 3GPP 5th- generation (5G) new radio (NR) mobile communication system standards.

Hereinafter, embodiments of the disclosure are described based on a communication or broadcasting system using LDPC codes. However, this is merely provided as an example to simplify the description and to avoid redundant descriptions for different channel coding techniques. Various embodiments of the disclosure may be easily modified and applied to communication and broadcasting systems using other channel coding techniques, including turbo codes.

Characteristics of LDPC codes as channel coding are described. LDPC codes are linear codes, and each LDPC code is typically defined by a parity-check matrix. The number of input bits to be encoded using an LDPC code is denoted by *K*, and the number of output bits of an encoded result is denoted by *N.* In terms of coding theory, the number of input bits *K* is referred to as a code dimension, and the number of output bits *N* is referred to as a code length. A code rate, which is one of important characteristics of channel codes, is defined as *R = K*/*N*, and a value *M = N - K*, obtained by subtracting the code dimension from the code length, is referred to as a number of parity bits and a number of redundant bits.

An LDPC code having a code dimension K and a code length *N* is defined by a parity-check matrix $H ∈ {F}_{2}^{M \times N}$. All valid codeword vectors $x ∈ {F}_{2}^{N}$ generated by the LDPC code defined by the parity-check matrix **H** satisfy the relationship of Equation 1.${Hx}^{T} = 0$

In Equation 1, $0 ∈ {F}_{2}^{M}$ denotes a zero vector of length *M*. According to Equation 1, a codeword vector **x** generated by encoding with an LDPC code defined by the parity-check matrix **H** belongs to a nullspace for the parity-check matrix **H.** A row vector corresponding to a j-th row of **H** is denoted by ${h}_{j} ∈ {F}_{2}^{N}$, and an element in the j-th row and an i-th column of **H** is denoted by ${h}_{ji} ∈ {F}_{2}$. Encoding and decoding of the LDPC code are performed based on the parity-check matrix **H.**

Operations of an LDPC code defined by a parity-check matrix **H** are described in detail with reference to drawings. Decoding of the LDPC code may be understood as a belief-propagation (BP) process in which messages are iteratively exchanged on a bipartite graph corresponding to the parity-check matrix **H.**

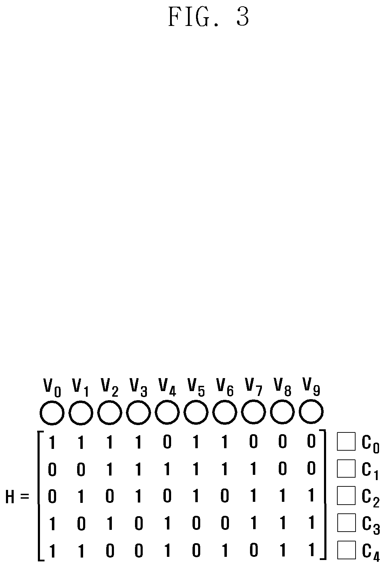

FIG. 3 illustrates an example of a parity-check matrix of an LDPC code to which various embodiments of the disclosure are applicable. Specifically, FIG. 3 illustrates an example of a parity-check matrix **H** E ${F}_{2}^{5 \times 10}$ of a binary LDPC code in which the number of rows is *M = N - K =* 5 and the number of columns is *N =* 10.

The number of 1s in a parity-check matrix is referred to as density, and the density determines computational complexity of encoding and decoding. Density of a typical parity-check matrix of an LDPC code is very low relative to a total size *NM* of the parity-check matrix, and this characteristic is a reason why this class of codes is referred to as a low-density parity check code. However, it should be noted that the parity-check matrix illustrated in FIG. 3 is an example of an LDPC code having very small *N* and M, and thus has a relatively high density. Typically designed LDPC codes have larger *N* and M than the example illustrated in FIG. 3, and density of the parity-check matrix may be much lower.

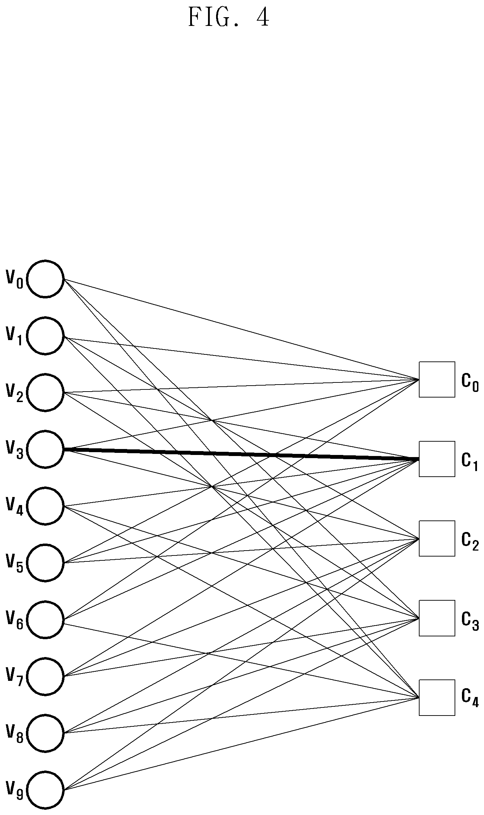

FIG. 4 illustrates an example of a binary graph corresponding to a parity-check matrix to which various embodiments of the disclosure are applicable. Specifically, FIG. 4 illustrates a bipartite graph 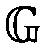 formed when the parity-check matrix **H** of FIG. 3 is considered as a biadjacency matrix.

A bipartite graph 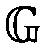 consists of a set *V* of variable nodes (|*V*| = *N*)*,* a set 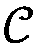 of check nodes (| 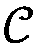 | *= N - K*)*,* and a set *ε* of edges connecting elements of the two sets. According to conventional graph theoretic notation, (*vᵢ,cⱼ*) ∈ *ε* indicates that an i-th variable node *vᵢ* E *V* and a j-th check node *cⱼ* ∈ *C* are connected. Conversely, (*vᵢ,cⱼ*) ∉ *ε* indicates that the i-th variable node *vᵢ* ∈ *V* and the j-th check node *cⱼ* ∈ C are not connected. For a parity-check matrix **H,** when a value of an element *hⱼᵢ* in a j-th row and an i-th column is 1, (*vᵢ,cⱼ*) ∈ *ε*, and when the value of *hⱼᵢ* is 0, (*vᵢ,cⱼ*) ∉ *ε.*

Variable nodes correspond to respective bits of a codeword output vector $x ∈ {F}_{2}^{N}$, and an i-th variable node *vᵢ* ∈ *V* corresponds to an i-th codeword bit *xᵢ* having a same index. A check node represents a linear equation indicated by an inner product, over a binary field, between each row of a parity-check matrix **H** and the codeword vector **x**. Specifically, a j-th check node *cⱼ* ∈ 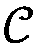 represents a linear equation corresponding to ${h}_{j} ⋅ x = {\sum }_{i = 0}^{N - 1} {h}_{ji} {x}_{i} = 0$. This linear equation indicates that a binary sum (i.e., modulo-2 sum or bitwise XOR) of bit values corresponding to all variable nodes connected to the *j*-th check node in a bipartite graph given by **H** is equal to 0. Belief-propagation (BP) decoding of an LDPC code may be understood as an iterative message exchange process using relationships between variable nodes and check nodes in the graph.

LDPC codes are utilized in various communication and broadcasting systems and are designed and used to satisfy requirements according to characteristics of the respective systems.

For example, one of required characteristics of channel codes for communication systems is length flexibility. In communication systems, a number of information bits to be transmitted may vary for each transmission according to a message to be transmitted. For example, when multimedia information such as video is transmitted, the number of information bits may be large. Conversely, when a text message is transmitted, the number of information bits may be small. Further, in communication systems, an amount of communication resources, such as time and frequency resources available for transmission of specific information, may vary for each transmission due to various reasons. For example, a total amount of available communication resources may vary, or an amount of communication resources allocated for transmission of corresponding information from among the total available resources may vary. Because the number of bits to be transmitted varies for each transmission instance, channel codes used in communication systems should be designed to flexibly process encoding and decoding in situations in which numbers of input bits and output bits vary.

Another required characteristic of channel codes for communication systems is rate flexibility. In communication systems, particularly mobile communication systems, channel quality between a transmitter and a receiver may vary over time. For example, when a receiver physically moves, a distance between the transmitter and the receiver may change, and thus a channel environment, such as path loss and multipath fading, may also change. When channel quality is good, a transmitter may increase a code rate (i.e., reduce a number of parity bits) to achieve error-free encoding and decoding through efficient utilization of communication resources. Conversely, when channel quality is poor, the transmitter may decrease a code rate (i.e., increase the number of parity bits) to improve a probability of overcoming poor channel conditions. Therefore, channel codes used in communication systems should be designed to flexibly adjust code rates according to channel conditions.

LDPC codes for practical communication and broadcasting systems are designed to have the above-described required characteristics (flexible code-length adjustment and flexible code-rate adjustment). For example, in a 3GPP NR mobile communication system, LDPC codes satisfying the above-described required characteristics are designed and used.

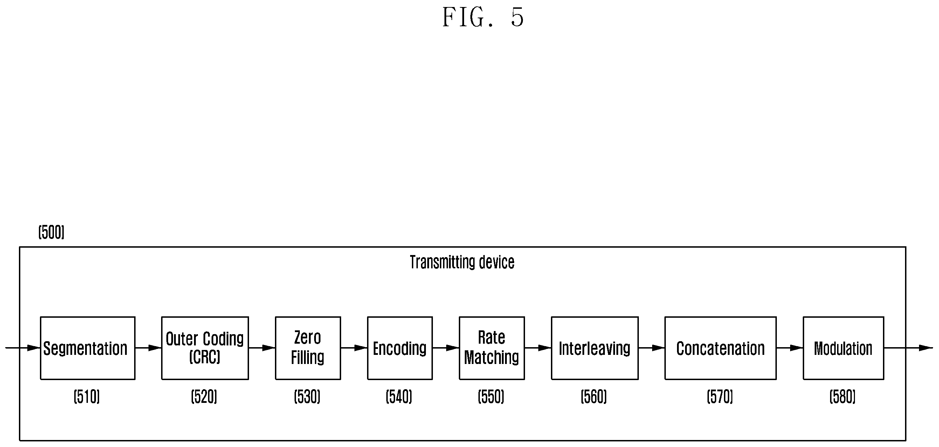

FIG. 5 is a block diagram illustrating a transmitting device according to various embodiments of the disclosure. More specifically, FIG. 5 illustrates an example of a process of performing channel encoding and a series of operations performed by a transmitter according to various embodiments of the disclosure.

With reference to FIG. 5, a transmitting device 500 (or transmitter) may include a segmentation unit 510, an outer encoding unit 520, a zero addition unit 530, an LDPC encoding unit 540, a rate-matching unit 550, an interleaving unit 560, a combining unit 570, and a modulation unit 580 in order to LDPC-encode and modulate an input bit sequence for transmission. Examples of modulation schemes include binary phase shift keying (BPSK), π/2-BPSK, quadrature phase shift keying (QPSK), 16-quadrature amplitude modulation (QAM), 64-QAM, 256-QAM, 1024QAM, and various other modulation techniques may also be used. The components illustrated in FIG. 5 are components for performing encoding and modulation on an input bit sequence, and are merely illustrative, in some cases, some of the components illustrated in FIG. 5 may be omitted or modified, and additional components may be included.

The transmitting device 500 determines code parameters to be used for an LDPC code based on given scheduling parameters, such as a number of input bits, a number of final output bits, and a code rate corresponding to a relationship therebetween, for encoding and modulation. The code parameters may include a parity-check matrix of the LDPC code to be used and information related thereto, information for segmentation, information for rate-matching (shortening, puncturing, repetition, and the like), information for bit interleaving, information for modulation, and the like.

Information bits that the transmitting device 500 intends to transmit may be referred to as a transport block (TB). Accordingly, a number of bits included in the transport block may be referred to as a transport block size (TBS). The transport block may be a result obtained by encoding using an externally concatenated code, such as cyclic redundancy check (CRC) encoding described above.

In a general communication system, the number of bits to be transmitted, i.e., a TBS (or a sum of the TBS and the number of parity bits generated by an externally concatenated code), may vary according to circumstances. When the TBS is greater than a maximum number of input bits that may be encoded using the determined parity-check matrix **H**, the transport block may be divided into two or more code blocks (CB), i.e., segmented (510). Each segmented code block is input to one LDPC encoder. When the number of input bits is less than or equal to a preconfigured value, segmentation is not performed. The number of code blocks determined or calculated through the above process is denoted by *C*. For indices r = 0, *..., C* - 1, an r-th code block is represented by ${a}_{r} ∈ {F}_{2}^{{A}_{r}}$, where *Aᵣ* denotes a length of the corresponding code block.

Each segmented code block may be encoded (520) using a concatenated outer code. Examples of the outer code may include CRC encoding, and the disclosure is not limited to a particular coding technique. Whether to perform outer encoding and a type of outer code may be differently determined according to whether segmentation has been performed. Outer encoding may be used to improve performance by assisting a decoding operation of an LDPC code performed at a receiver. Outer encoding may also be used to verify validity of a decoding result of the LDPC code obtained at the receiver.

An outer codeword obtained by encoding the r-th code block **a***ᵣ* is represented by a vector ${b}_{r} ∈ {F}_{2}^{{B}_{r}}$, where *Bᵣ* denotes a length thereof (*Bᵣ* ≥ *Aᵣ*). If outer encoding is not performed, **b***ᵣ* = **a***ᵣ*. For consistency, in the description of the disclosure, a result obtained by setting **b***ᵣ* = **a***ᵣ* even when outer encoding is not performed will also be referred to as an outer codeword. The bit sequence generated in this manner is input to an LDPC encoder.

Outer codewords for respective code blocks are independently LDPC-encoded. Therefore, when a processing procedure for one code block is understood, an overall processing operation of the transmitting device may be understood. Accordingly, an LDPC encoding process for one code block will be described below. In the following description, for brevity, a subscript r representing an index of a code block is omitted, such that a code block is represented by $a ∈ {F}_{2}^{A}$, and an outer codeword obtained by outer encoding is represented by $b ∈ {F}_{2}^{B}$.

The externally encoded outer codeword $b ∈ {F}_{2}^{B}$ having a length *B* is encoded using an LDPC code having a code dimension K. The LDPC code used for encoding may be selected such that the code dimension K is as close as possible to the length *B* while being greater than or equal to the length *B.* When the length *B* of the outer codeword is smaller than the code dimension K, *F = K - B* filler bits may be added to an encoding input bit sequence. When the length *B* of the outer codeword is equal to the code dimension K, the number of filler bits becomes *F = K - B =* 0.

Filler bits may be added to the outer codeword **b** in various manners. For example, an appending scheme may be used in which *F = K - B* filler bits are added to an end of **b.** A method for adding filler bits is not limited to a specific manner. The filler bits may be determined to have arbitrary fixed values, and generally may be determined to have a fixed bit value of 0. Accordingly, a process of adding the filler bits may also be referred to as zero filling, zero padding, or zero appending (530). Because filler bits do not carry actual information, the filler bits may be excluded from final transmission. Excluding the filler bits from final transmission may be understood as shortening, which is one of code modification methods for reducing a code length and a code dimension by an equal amount. An encoder input vector $c ∈ {F}_{2}^{K}$ denotes a result of adjusting the length of the outer codeword **b** to the code dimension K of an LDPC code used for encoding by performing an operation such as zero filling. The filler bits may also be referred to as shortened bits, and hereinafter, the term "shortened bit" will be used in the description of the disclosure.

After matching the input length K for LDPC encoding, LDPC encoding is performed (540). LDPC encoding is performed based on a parity-check matrix $H ∈ {F}_{2}^{M \times N}$ determined according to the scheduling parameters, code parameters, and the like. Specifically, LDPC encoding is a process of generating a mother codeword vector $x ∈ {F}_{2}^{N}$ having a length *N* and satisfying Equation 1 based on the encoder input vector **c** obtained through the above-described series of processes. In other words, LDPC encoding is a process of obtaining a mother codeword vector **x** mapped from the encoder input vector **c** and satisfying Equation 1 based on the parity-check matrix **H**. When a bit sequence of the input code block appears unchanged in the mother codeword bit sequence, the code is referred to as a systematic code, otherwise, the code is referred to as a non-systematic code.

A mother codeword vector **x** having a length *N* is generated as an output of LDPC encoding, and the mother codeword undergoes a rate-matching process to be modified to fit to a transmission environment and transmission resources (550). A length of a coded bit sequence to be finally transmitted for a corresponding code block is referred to as a rate-matching size E, which is a parameter determined by scheduling according to, for example, the transmission environment and transmission resources. Similar to the notation described above, a rate-matching size of an *r*-th code block may be represented by *Eᵣ*, and it should be noted that, because the following description describes a series of encoding processes for one code block, the subscript *r* may be omitted and the rate-matching size may simply be represented by *E* for simplicity. The rate-matching process may be understood as a process of generating a codeword vector $e ∈ {F}_{2}^{E}$ having a length *E* from a mother codeword vector **x** having a length N. To more clearly distinguish the codeword vector **e** from the mother codeword vector **x**, the codeword vector **e** may also be referred to as a transmitted codeword vector.

The rate-matching process may be implemented in various manners. For example, the rate-matching process may be systematically performed according to simple rules using a circular buffer. A size of the circular buffer to be used is denoted by *N*_{CB}, and *N*_{CB} may differ from the length N of the mother codeword. For example, *N*_{cb} may be determined to be less than or equal to N. For example, in a 3GPP NR LDPC encoding system, unless special constraints are present, *N*_{CB} may be determined as *N* - 2*Z* (where Z denotes a lifting size to be described later and is a positive integer between 2 and 384). When a circular buffer having a length *N*_{CB} is represented by d = $\left({d}_{0},{d}_{1},…,{d}_{{N}_{cb} - 1}\right) ∈ {F}_{2}^{{N}_{cb}}$, each bit of the circular buffer is determined from bits of a mother codeword x = (*x*₀,*x*₁, ... ,*x*_{*N*-1}) according to Equation 2. That is, each bit of the circular buffer is determined to satisfy Equation 2.${d}_{i} = {x}_{2 Z + i} , i = 0 , 1 , … , {N}_{cb} - 1$

When the circular buffer d is constructed according to Equation 2, first 2Z bits of the mother codeword x are not stored or written in the circular buffer and are thus excluded from transmission. A 3GPP NR LDPC code is a systematic code, and an encoding input bit sequence (i.e., an information bit sequence) appears unchanged in first K bits of a mother codeword having a length *N*. Therefore, in the 3GPP NR LDPC encoding system, systematic puncturing or information puncturing occurs, in which 2Z bits of information bits are fixedly punctured. As fewer information bits are transmitted in this manner, parity bits generated during an encoding process are additionally transmitted by a corresponding amount.

The rate-matching unit selects *E* bits by sequentially reading the circular buffer **d** constructed as described above from a predetermined starting point *s* (e.g., in the order of *dₛ,d*_{*s*+1},*d*_{*s*+2}, ...) and cyclically reading the circular buffer (e.g., moving to a first point *d*₀ of the buffer after reaching an end position *d*_{*N*_{cb}-1} of the buffer). The starting point *s* for reading the circular buffer may be determined in consideration of use of hybrid automatic repeat request (HARQ). Further, when selecting *E* bits from the circular buffer, the *F* shortened bits added in process 530 are not selected. When *E* < *N*_{cb} - *F*, puncturing occurs in which (*N*_{cb} - *F*) - *E* codeword bits, excluding the shortened bits stored in the circular buffer, are excluded from transmission. When *E* > *N*_{cb} - *F*, repetition occurs in which all or part of the codeword bits stored in the circular buffer are transmitted two or more times.

A bit sequence having a length *E* generated through rate-matching may be transmitted using a bit-interleaved coded modulation (BICM) scheme. In this case, interleaving may be performed on the rate-matched bit sequence in order to appropriately map bits to modulation symbols (560).

When the transport block is segmented into two or more code blocks, concatenation may be performed to combine outputs of the above-described series of encoding processes for respective code blocks into a single sequence (570). Here, results of the respective code blocks may be sequentially concatenated, or the results of the code blocks may be interleaved and concatenated according to a predetermined pattern.

After all bit-level operations are performed, a baseband signal to be transmitted is generated through modulation (580). During the modulation process, various additional operations may be performed to allow a receiving device, which will be described later, to effectively demodulate and recover the signal. The baseband signal may be transmitted while being carried on a carrier of a band used for transmission. Through the above-described series of operations, bits of the transport block are transmitted after undergoing encoding and modulation.

Although functional constitutions for LDPC encoding have been described with reference to FIG. 5, in some cases, the transmitting device 500 may further include components for controlling operations thereof.

According to an embodiment, the transmitting device 500 may additionally include a communication unit. The communication unit performs functions for transmitting and receiving signals through a wireless channel. For example, the communication unit may perform conversion functions between baseband signals and bit sequences according to physical layer specifications of a communication system. For example, when transmitting data, the communication unit generates complex symbols by encoding and modulating a transmitted bit sequence. Further, when receiving data, the communication unit restores a received bit sequence by demodulating and decoding a baseband signal. Further, the communication unit up-converts the baseband signal into a radio frequency (RF) band signal and transmits the RF band signal through an antenna, and down-converts an RF band signal received through the antenna into a baseband signal. According to various embodiments, the transmitting device 500 may transmit an LDPC-encoded signal to a receiving device 600 to be described later.

To this end, the communication unit may include a transmission filter, a reception filter, an amplifier, a mixer, an oscillator, a digital-to-analog converter (DAC), an analog-to-digital converter (ADC), and the like. Further, the communication unit may include a plurality of transmission and reception paths. Furthermore, the communication unit may include at least one antenna array including a plurality of antenna elements. In terms of hardware, the communication unit may include a digital unit and an analog unit, and the analog unit may include a plurality of sub-units according to operating power, operating frequency, and the like.

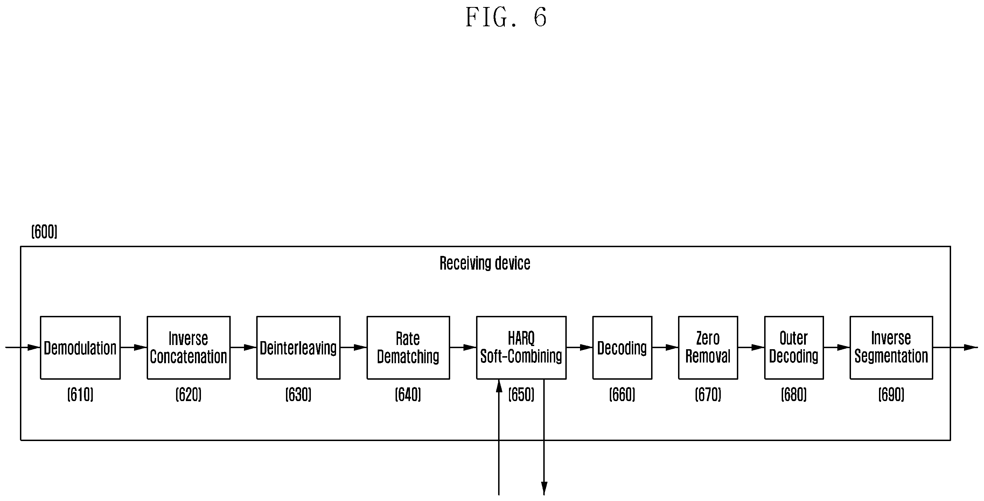

FIG. 6 is a block diagram illustrating a receiving device according to various embodiments of the disclosure. More specifically, FIG. 6 illustrates an example of a process in which a receiver performs channel decoding and a series of operations according to various embodiments of the disclosure.

With reference to FIG. 6, a receiving device (receiver) 600 may include a demodulator 610, an inverse combining unit 620, a deinterleaving unit 630, a rate dematching unit 640, a HARQ combining unit 650, an LDPC decoding unit 660, a zero removal unit 670, an outer decoding unit 680, and a desegmentation unit 690 in order to estimate correct information bits from a received signal.

Like the transmitting device 500, the receiving device 600 identifies or determines various parameters required for a receiving operation based on scheduling information, coding parameters, and the like. A series of operations performed by the receiver described below are performed based on the identified and determined parameters.

The operation of the demodulator 610 may include various processes in some cases. For example, the demodulator 610 may be divided into a process of obtaining a channel estimation result based on a received signal and a soft demapping process for determining values required for forward error control (FEC) decoding corresponding to transmitted codeword bits from a demodulated signal or symbol based on the channel estimation result (e.g., a log-likelihood ratio (LLR) or a value corresponding thereto). In this case, operations within the demodulator may be further divided into a channel estimation block, a soft demapping block, and the like. Various other subdivisions are possible according to a structure of the system.

In the following description of an embodiment of the disclosure, operations are described assuming a receiving device 500 that calculates or obtains and processes log-likelihood ratio (LLR) values for codeword bits. However, metric values processed by the receiving device according to the disclosure are not limited to LLR values, and any equivalent value may be used.

If a signal transmitted by the transmitting device 500 consists of two or more code blocks, the receiving device 600 performs inverse concatenation, which is an inverse process of concatenation (570) performed by the transmitting device 500, to separate LLRs for respective code blocks (620). If the number of code blocks is one, inverse concatenation is not performed. Through this process, the receiving device 600 obtains an LLR sequence for each code block, and a length of the LLR sequence for an r-th code block is a rate matching size *Eᵣ*. Similar to the description of the transmitting device 500 above, hereinafter, a series of decoding processes performed by the receiving device 600 for one code block will be described, and for brevity of description, the rate matching size may be expressed as E without a subscript *r*.

If the transmitting device 500 performs interleaving (560), the receiving device 600 performs deinterleaving, which is an inverse process thereof (630). This process changes an order of an LLR sequence of a code block according to a predetermined pattern, and a sequence length E is unchanged. The LLR sequence obtained through deconcatenation and deinterleaving in this manner is denoted by Ψ *=* (*ψ*₀,*ψ*₁, ..., *ψ*_{*E*-1}).

Subsequently, the receiving device 600 performs rate dematching (640), which is an inverse process of rate matching (550), to obtain an LLR sequence or a corresponding value for a codeword processable by an LDPC decoder. That is, the rate dematching unit 640 of the receiving device 600 generates an LLR sequence A = (*λ*₀,*λ*₁, ..., *λ*_{*N*_{cb}-1}) for a mother codeword based on the LLR sequence Ψ = (*ψ*₀,*ψ*₁, ..., *ψ*_{*E*-1})obtained through the preceding process. An i-th LLR *λᵢ* corresponds to a mother codeword bit *xᵢ*.

For example, when rate matching using a circular buffer is performed in a 3GPP NR LDPC encoding system, an LLR sequence for a mother codeword may be generated by performing rate dematching through the following process.
1) All values of the LLR sequence A = (*λ*₀,*λ*₁, ..., *λ*_{*N*_{cb}-1}) for the mother codeword are initialized to 0.
2) Set a position index for the rate-dematched LLR sequence A to *i* = s. A buffer start position s is a scheduling parameter that may be identified by a transmitter and a receiver through a series of processes. Further, set a position index for the input LLR sequence Ψ to *j* = 0.
3) A value of *λᵢ* is determined by performing one of the following operations according to processing of a mother codeword bit determined through an encoding process performed by the transmitter.
   ▪ If *xᵢ* is shortened at the transmitter (i.e., a shortened bit having a value of 0), *λᵢ* is determined as an LLR value indicating that a probability of a bit value being 0 is maximum, or as a corresponding value. Then, i is incremented by *i +* 1, while *j* remains unchanged.
   ▪ If *xᵢ* is not a shortened bit, *λᵢ* is determined as *λᵢ* = *λᵢ* + *ψⱼ*. That is, *ψⱼ* is accumulated into a current value of *λᵢ*. If the decoder performs fixed-point operations, an appropriate saturation operation or clipping operation may be performed to prevent overflow. Then, i is incremented to *i = i +* 1 and *j* is incremented to *j = j +* 1.
4) When an index i for the rate-dematched LLR sequence A becomes *N*_{cb} (i.e., reaches an end), i is reset to 0. Then, the process of 3) above is repeatedly performed. This iterative operation is performed until all LLRs of the input LLR sequence Ψ are applied to the rate-dematched LLR sequence A, that is, until *j* becomes E.

Through the above rate dematching process, an LLR sequence Λ = (*λ*₀,*λ*₁,...,*λ*_{*N*_{cb}-1}) for the circular buffer is obtained. As a result of the above-described series of processes, an LLR at a shortened bit position is determined as an LLR value indicating that a probability of a bit value 0 is maximum, or as a corresponding value. Because no value is accumulated in an LLR at a punched bit position, an initial value remains 0, which indicates that probabilities of bit 0 and bit 1 are equally 0.5, and thus the LLR is not biased toward either value.

According to the decoder operation of the above embodiment, a rate-dematched LLR sequence A = (*λ*₀, *λ*₁, ..., *λ*_{*N*-1}) having a length *N* may be generated, including 2Z systematically punctured LLRs. In this case, the rate dematching process may be modified and performed as follows.
1) All values of the LLR sequence A = (*λ*₀, *λ*₁, ..., *λ*_{*N*-1}) for the mother codeword are initialized to 0.
2) Set a position index for the rate-dematched LLR sequence A to i = s + 2Z. The buffer start position s is a scheduling parameter that may be identified by a transmitter and a receiver through a series of processes. Further, set a position index for the input LLR sequence Ψ to *j* = 0.
3) The value of *λᵢ* is determined by performing one of the following operations according to processing of a mother codeword bit determined through an encoding process performed by the transmitter.
   ▪ If *xᵢ* is shortened at the transmitter (i.e., a shortened bit having a value of 0), *λᵢ* is determined as an LLR value indicating that a probability of a bit value being 0 is maximum, or as a corresponding value. Then, i is incremented to *i = i +* 1, while *j* remains unchanged.
   ▪ If *xᵢ* is not a shortened bit, *λᵢ* is determined as *λᵢ* + *ψⱼ*. That is, *ψⱼ*is accumulated into an existing value of *λᵢ*. If the decoder performs fixed-point operations, an appropriate saturation operation or clipping operation may be performed to prevent overflow. Then, i is incremented to *i = i +* 1 and *j* is incremented to *j = j +* 1.
4) When an index i for the rate-dematched LLR sequence A becomes *N* (i.e., reaches an end), i is reset to 2Z. Then, the process of 3) above is repeatedly performed. The iterative operation is performed until all LLRs of the input LLR sequence Ψ are reflected in the rate-dematched LLR sequence A, that is, until *j* becomes E.

In the following description of an embodiment of the disclosure, subsequent operations are described under an assumption that a rate-dematched LLR sequence is generated without including LLRs for systematically punched bits. That is, it is assumed that the rate-dematched LLR sequence is obtained as A = (*λ*₀, *λ*₁, ..., *λ*_{*N*_{cb}-1}). If systematically punched bits are taken into account, it is sufficient to consider prepending2Z LLRs having a value of 0 to A having the length *N*_{cb}*.* Therefore, selecting one assumption for brevity of the above description does not affect a final decoding result.

In a mobile communication system, HARQ operations may be performed to ensure integrity of data and efficiently utilize overall communication transmission resources. In this case, the receiving device 600 manages, for each code block, a HARQ LLR sequence Λ^{HARQ} = (*λ*₀,*λ*₁, ..., *λ*_{*N*_{cb}-1}) using a separate memory or the like. Further, the receiving device 600 performs soft combining for HARQ based on A = (*λ*₀, *λ*₁, ..., *λ*_{*N*_{cb}-1}) and ${Λ}^{HARQ} = \left({λ}_{0}^{HARQ},{λ}_{1}^{HARQ},…,{λ}_{{N}_{cb} - 1}^{HARQ}\right)$ (650).
- If this transmission is an initial transmission, Λ_{HARQ} is determined as A. That is, for all *i* = 0, 1, ... , *N*_{cb} - 1, assignment of ${λ}_{i}^{HARQ} ← {λ}_{i}$ is performed. Elements of the rate-dematched LLR sequence A are not separately updated.
- If this transmission is a retransmission (i.e., a second transmission) or a subsequent transmission, corresponding elements of Λ^{HARQ} and A are added together. That is, element-wise addition of the two vectors is performed. Specifically, for all i = 0,1, ..., *N*_{cb} - 1, A is updated according to ${λ}_{i} ← {λ}_{i} + {λ}_{i}^{HARQ}$. Λ^{HARQ} may be updated in consideration of various types of memory management, but typically, Λ^{HARQ} may be updated to A (i.e., ${λ}_{i}^{HARQ}$ is set to *λᵢ* for all *i* = 0, 1, ..., *N*_{cb} - 1) and written back to a corresponding memory.

If there is no HARQ operation, the above process may be omitted.

The LDPC decoder receives an LLR sequence A = (*λ*₀,*λ*₁, ..., *λ*_{*N*_{cb}-1}) generated through the above-described series of processes and performs decoding (660). As described above, the input LLR sequence may be a sequence including LLRs for 2Z systematically punctured bits. In this case, the receiving device 600 may modify the input LLR sequence A or perform decoding using only a part of A based on code parameters (i.e., code dimension K, code length *N,* rate matching size E, code rate *K*/*E,* and various parameters calculated based thereon, size information of a parity-check matrix, and the like). Specifically, when puncturing occurs in a mother codeword due to a high transmission code rate, the receiving device 600 may reduce decoding complexity and processing time by excluding, from decoding, a portion of the parity-check matrix corresponding to punctured bits according to a condition.

Decoding of an LDPC code is a process of performing belief-propagation (BP) based on LLRs for codeword bits. During the BP decoding process, message passing operations are performed to iteratively update a posteriori LLRs (AP-LLRs) for the codeword bits. A maximum number of iterations for the iterative decoding is determined based on requirements for decoding performance, decoding time, and the like.

Typically, a syndrome check is performed whenever the above iterative decoding process is performed once or a predetermined number of times. This process verifies whether an estimated bit sequence x̂ obtained by performing hard decision based on updated AP-LLRs belongs to a null space of a parity-check matrix, that is, whether **Hx̂***^{T}* = **0** is satisfied based on Equation 1, which is a condition for the LDPC code. It should be noted that only a portion of the estimated bit sequence **x̂** may be considered in the syndrome check, and in this case, the syndrome check equation may also be modified. Validity of the estimated bit sequence **x̂** decoded through the syndrome check is verified, and based thereon, it is determined whether to early terminate decoding.

As described above, when bits of a mother codeword are punctured, an LDPC decoder may perform decoding using a sub parity-check matrix (sub-PCM) **H**', which is composed of submatrices of a parity-check matrix **H**, in order to reduce decoding complexity and processing time. In this case, the above-described series of BP decoding processes may be modified according to the sub-parity-check matrix **H**'. Decoding operations using the modified parity-check matrix **H**' are optional, but may typically be used to reduce complexity.

The estimated bit sequence for the code block obtained after LDPC decoding may include shortened bits having no valid information due to zero filling (530) performed by the transmitting device 500. Therefore, zero removal (670) may be performed to exclude shortened bits from the estimated bit sequence as an inverse process of zero filling performed by the transmitting device 500.

When outer encoding (520) is performed on the code block, the bit sequence obtained as a result of LDPC decoding may be decoded based on the outer encoding (680). Typically, an error detection code such as a CRC code is concatenated, and in this case, validity of the bit sequence obtained through LDPC decoding may be additionally checked.

If a transport block consists of multiple code blocks, inverse segmentation (690) may be performed to derive a final result by concatenating results of respective code blocks. This process may be understood as an inverse process of segmentation (510) performed by the transmitting device 500.

Components illustrated in FIG. 6 are components for performing functions corresponding to those illustrated in FIG. 6, and are merely examples, and in some cases, some components may be omitted or modified, and additional components may be further included.

Embodiments of the disclosure relate to an LDPC decoding operation (660) among a series of processes performed by the receiver. As described above, the LDPC decoding operation is performed based on a given LLR sequence A. An initial LLR sequence input to the decoding operation may also be referred to as an intrinsic LLR sequence (or an original LLR/original sequence). This is to distinguish the intrinsic LLR sequence from a posteriori LLRs (AP-LLRs) updated through iterative belief propagation during the decoding process.

An LLR represents an estimate of a value of a corresponding codeword bit and confidence or reliability of the estimate. Specifically, in an embodiment, an LLR *λᵢ* for a codeword bit *xᵢ* may be defined according to Equation 3 based on a corresponding symbol *yᵢ* observed by the receiver. That is, the LLR *λᵢ* for the codeword bit *xᵢ* is determined to satisfy Equation 3.${λ}_{i} = log \frac{p \left({y}_{i}\left|{x}_{i}=0\right.\right)}{p \left({y}_{i}\left|{x}_{i}=1\right.\right)}$

According to the definition of Equation 3, an LLR is a value obtained by taking a logarithm of a ratio of likelihoods, i.e., probabilities of an observed symbol *yᵢ* for values of a codeword bit *xᵢ*.

In Equation 3, if a likelihood for a value 0 of a codeword bit *xᵢ* is greater than a likelihood for a value 1 of the codeword bit *xᵢ*, the LLR *λᵢ* has a positive value greater than 0. Conversely, in Equation 3, if the likelihood for the value 1 of the codeword bit *xᵢ* is greater than the likelihood for the value 0 of the codeword bit *xᵢ*, the LLR *λᵢ* has a negative value smaller than 0. Therefore, a sign of the LLR indicates a more likely value among possible values of the corresponding codeword bit.

In another embodiment, an LLR may be defined differently. For example, a numerator and a denominator in a fraction inside the logarithm of Equation 3 may be swapped with each other. Such a definition of the LLR merely results in reversing a sign of the LLR defined according to Equation 3 (i.e., changing + to - and - to +). Although operations according to an embodiment of the disclosure are described based on the LLR defined according to Equation 3, even when the LLR is differently defined, the operations may be applied without substantial difference by reversing the sign.

In Equation 3, if a difference between a likelihood for the value 0 of the codeword bit *xᵢ* and a likelihood for the value 1 of the codeword bit *xᵢ* is large, an absolute value |*λᵢ*| of the LLR *λᵢ* becomes very large. As an extreme example, if the likelihood for the value 0 of the codeword bit *xᵢ* is 1 and the likelihood for the value 1 of the codeword bit *xᵢ* is 0, the LLR *λᵢ* has a positive infinite value. As an opposite extreme example, if the likelihood for the value 0 of the codeword bit *xᵢ* is 0 and the likelihood for the value 1 of the codeword bit *xᵢ* is 1, the LLR*λᵢ* has a negative infinite value. However, if the likelihood for the value 0 of the codeword bit *xᵢ* and the likelihood for the value 1 of the codeword bit *xᵢ* are both 0.5, the LLR *λᵢ* has a value of 0. Therefore, an absolute value of the LLR may be interpreted as representing confidence or reliability of an estimate of a value of the codeword bit.

A process of configuring LLR values for shortened codeword bits and punctured codeword bits in the rate dematching unit 640 of the receiving device 600 is based on reliability represented by an absolute value of the LLR. The receiving device 600 does not receive a shortened bit, but clearly knows that a value thereof is 0. Therefore, an LLR value for the shortened bit is configured to a positive infinite value, indicating that the bit value is 0 and confidence or reliability thereof is high. In an actual implementation, the LLR value may be configured to an arbitrary positive value representable by a data type used. On the other hand, because the receiving device 600 does not have any information regarding a punctured bit, an LLR value for the shortened bit is determined to be 0, indicating that probabilities of two possible values of the codeword bit are both 0.5.

The absolute value of each element of an intrinsic LLR sequence Λ may be interpreted as a measure indicating how much a receiver observation for each codeword bit has been corrupted by noise. For example, if an absolute value |*λᵢ*| of an LLR *λᵢ* for a codeword bit *xᵢ* is large, it indicates that observation of the corresponding codeword bit has not been corrupted during a series of end-to-end transmission processes (including all related processes performed by a transmitter and a receiver). On the other hand, if the absolute value |*λᵢ*| of the LLR *λᵢ* for the codeword bit *xᵢ* is significantly small, i.e., close to 0, it indicates that observation of the corresponding codeword bit has been corrupted during the series of end-to-end transmission processes (including all related processes performed by a transmitter and a receiver).

The decoding operation (660) of the LDPC code is performed through iterative belief-propagation based on the intrinsic LLR sequence as described above. An example of belief-propagation decoding of the LDPC code will be described below. A structure and architecture of a decoder, algorithms used thereby, and the like may be configured in various manners, and the following description does not limit a scope of embodiments of the disclosure to a specific implementation. Embodiments of the disclosure may be applied to various decoding architectures and algorithms, and such application methods will be readily understood by those skilled in the art to which the disclosure pertains.

The decoder receives an intrinsic LLR sequence A as an input and updates an AP-LLR sequence Γ = (*γ*₀,*γ*₁,..., *γ*_{*N*-1}) through a belief-propagation process based thereon. It should be noted that regardless of whether the intrinsic LLR sequence A includes LLRs for 2Z systematically punctured bits, the AP-LLR sequence Γ = (*γ*₀,*γ*₁,..., *γ*_{*N*-1}) includes LLRs for the 2Z systematically punctured bits. At an initial stage of decoding, the AP-LLR sequence Γ is configured to the intrinsic LLR sequence A.

In an embodiment, if the intrinsic LLR sequence A does not include LLRs for systematically punctured bits (i.e., A = (*λ*₀,*λ*₁, ..., *λ*_{*N*_{cb}-1})), an initial AP-LLR sequence Γ = (*γ*₀,*γ*₁, ..., *γ*_{*N*-1}) may be configured according to Equation 4. That is, when the intrinsic LLR sequence A does not include LLRs for systematically punctured bits, the initial AP-LLR sequence may be determined to satisfy Equation 4.

${γ}_{i} ← \left\{\begin{matrix}0 , & if i < 2 Z \\ {λ}_{i - 2 Z} , & if i \geq 2 Z\end{matrix} for i=0,1,…, N-1\right.$

In an embodiment, if the intrinsic LLR sequence A includes LLRs for systematically punctured bits (i.e., A = (*λ*₀,*λ*₁, ..., *λ*_{*N*-1})), an initial AP-LLR sequence Γ = (*γ*₀,*γ*₁, ..., *γ*_{*N*-1}) may be configured according to Equation 5. That is, when the intrinsic LLR sequence A includes LLRs for systematically punctured bits, the initial AP-LLR sequence may be determined to satisfy Equation 5.

${γ}_{i} ← {λ}_{i} for i = 0 , 1 , … , N - 1$

As described above, it should be noted that when an LDPC decoder uses a sub parity-check matrix (sub-PCM) **H**' considering punctured bits, an actual code length considered in decoding may be smaller than a code length N of a mother codeword. Because whether a sub parity-check matrix is used is independent of detailed operations of the decoder, decoding operations according to embodiments of the disclosure will hereinafter be described assuming use of a parity-check matrix **H**. Embodiments of the disclosure may be applied to both cases in which a sub parity-check matrix is used and in which a sub parity-check matrix is not used.

The AP-LLR sequence configured as described above is updated at every iteration through iterative belief propagation operations of LDPC decoding. This process may be understood as message passing operations between a variable node (hereinafter, VN) and a check node (hereinafter, CN) on a bipartite graph corresponding to a parity-check matrix (or a sub parity-check matrix).

First, a message passed from a VN to a CN is determined based on an intrinsic LLR sequence or an AP-LLR sequence determined based thereon. A message from a VN to a CN (variable-to-check message, hereinafter, V2C message) transmitted from a VN *vᵢ* to a neighboring CN *cⱼ* is denoted by *α*_{*i*→*j*}. At an initial state of decoding, the V2C message is determined according to Equation 6. That is, in the decoding operation, an initial V2C message transmitted from the VN *vᵢ* to the neighboring CN *cⱼ* may be determined to satisfy Equation 6.

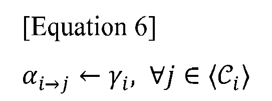

In Equation 6, 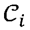 denotes a set of all neighboring CNs of the VN *vᵢ*, and 〈 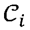 〉 denotes a set of indices of CNs belonging to 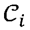 .

Each CN calculates a message to be passed to a neighboring VN based on V2C messages received from neighboring VNs. A message from a CN to a VN (check-to-variable message, hereinafter, C2V message) transmitted from a CN *cⱼ* to a neighboring VN *vᵢ* is denoted by *β*_{*j*→*i*}. The C2V message may be calculated according to Equation 7. That is, the C2V message may be determined to satisfy Equation 7.

${β}_{j \to i} ← 2 {tanh}^{- 1} \left({\prod }_{k ∈ \left〈{V}_{j}\right〉 \ \left\{i\right\}} tanh \left(\frac{{α}_{k \to j}}{2}\right)\right)$

In Equation 7, *Vⱼ* denotes a set of all neighboring VNs of a CN *cⱼ*, and 〈*Vⱼ*〉 denotes a set of indices of VNs belonging to *Vⱼ*. According to Equation 7, a C2V message *β*_{*j*→*i*} transmitted from the CN *cⱼ* to a neighboring VN *vᵢ* is calculated based on V2C messages received from all other neighboring VNs excluding the VN *vᵢ*.

The calculation of the C2V message according to Equation 7 may be approximated and modified in various manners. In an embodiment, the C2V message according to Equation 7 may be calculated according to Equation 8 using a so-called min-sum approximation method. That is, the C2V message may be determined to satisfy Equation 8. ${β}_{j \to i} ← A \times \left({\prod }_{k ∈ \left〈{V}_{j}\right〉 \ \left\{i\right\}} sgn \left({α}_{k \to j}\right)\right) \times max \left(\begin{matrix}{min}_{k ∈ \left〈{V}_{j}\right〉 \ \left\{i\right\}} \left|{α}_{k \to j}\right| - \\ B , 0\end{matrix}\right)$

In Equation 8, sgn(·) is a function that outputs a sign ±1 of an input value. Further, in Equation 8, A is a normalization value greater than 0, and B is an offset value greater than or equal to 0. The C2V message calculation according to Equation 8 is widely used because it is computationally simpler and easier to implement than the C2V message calculation according to Equation 7 while providing a good approximation of a result.

When CNs calculate C2V messages for neighboring VNs, each VN updates an AP-LLR and V2C messages thereof based on an intrinsic LLR thereof and C2V messages received from neighboring CNs. First, an AP-LLR *γᵢ* of a VN *vᵢ* may be calculated according to Equation 9. That is, the AP-LLR *γᵢ* of the VN *vᵢ* may be determined as a value satisfying Equation 9.

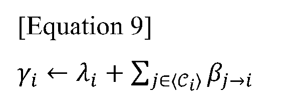

The V2C message transmitted from the VN *vᵢ* to a neighboring CN *cⱼ* may be calculated according to Equation 10. That is, the V2C message transmitted from the VN *vᵢ* to the neighboring CN *cⱼ* may be determined as a value satisfying Equation 10.

${α}_{i \to j} ← {λ}_{i} + {\sum }_{k ∈ \left〈{C}_{i}\right〉 \ \left\{j\right\}} {β}_{k \to i}$

The V2C message calculated according to Equation 10 may also be more simply calculated according to Equation 11 using the AP-LLR *γᵢ* calculated according to Equation 9. That is, the V2C message may be determined as a value satisfying Equation 11.${α}_{i \to j} ← {γ}_{i} - {β}_{j \to i}$

Estimation for each codeword bit may be performed based on the AP-LLR updated according to Equation 9. Based on the updated AP-LLR *γᵢ*, an estimate *x̂ᵢ* for a codeword bit *xᵢ* may be obtained through a hard decision process according to Equation 12.${\hat{x}}_{i} ← \left\{\begin{matrix}0 , & if {γ}_{i} > 0 \\ 1 , & if {γ}_{i} < 0\end{matrix}\right.$

The hard decision according to Equation 12 is based on the definition of the LLR in Equation 3. If the definition of the LLR is different, the hard decision of Equation 12 may be modified accordingly. When the LDPC decoder is implemented using a fixed-point representation method, the AP-LLR *γᵢ* may be exactly 0. In this case, during the hard decision process of Equation 12, the estimate *x̂ᵢ* may be determined according to a predetermined rule. In an embodiment, when the AP-LLR *γᵢ* is 0, the estimate *x̂ᵢ* may be determined by fixing the estimate *x̂ᵢ* to one of 0 and 1. In an embodiment, when the AP-LLR *γᵢ* is 0, the estimate *x̂ᵢ* may be determined by randomly selecting one of 0 and 1.

Once estimates of all codeword bits are obtained as described above, the receiving device identifies whether the estimated codeword vector **x̂** = (*x̂*₀,*x̂*₁, ..., *x̂*_{*N*-1}) is valid for the given LDPC code, that is, whether **Hx̂***^{T}* = 0 is satisfied. This process is referred to as a syndrome check.

If the estimated codeword vector **x̂** satisfies the syndrome check equation **Hx̂***^{T}* = **0,** because the estimated codeword vector is valid for the LDPC code used, the receiving device may output **x̂** as a result and early terminate decoding even if decoding has not performed for a preconfigured maximum number of decoding iterations.

If the estimated codeword vector **x̂** does not satisfy the syndrome check equation **Hx̂***^{T}* = **0**, the receiving device repeats processes of calculating a series of C2V messages, updating P-LLRs, calculating V2C messages, performing hard decisions, and the like within a preconfigured maximum number of decoding iterations.

If an estimated codeword vector **x̂** satisfying the syndrome check equation **Hx̂***^{T}* = 0 is not found within a preconfigured maximum number of decoding iterations, the receiving device may determine that decoding has failed and terminate the decoding process.

According to the syndrome check equation **Hx̂***^{T}* = **0,** a syndrome check may be performed on all elements of the estimated codeword vector. However, because the receiving device is interested in information bits included in the estimated codeword vector, the receiving device may determine the validity of the decoding result by using only a part of the syndrome check equation instead of using the entire syndrome check equation.

As in the above-described series of message exchange processes, initially given intrinsic LLR values are exchanged among neighboring nodes according to the structure of the bipartite graph and are used to update AP-LLRs. If the absolute value of an intrinsic LLR is small, the corresponding value does not significantly affect the belief-propagation decoding operation. In other words, low-reliability LLR values generated from observations interfered with or corrupted by the channel do not affect decoding.

Based on characteristics of this belief-propagation process, an LDPC code decoder may improve performance by processing low-reliability LLRs (i.e., LLRs having small absolute values) in a specific manner. Specifically, the LDPC code decoder may test all possible guesses for bits determined to have low-reliability and select one of them.

For example, the LDPC code decoder may identify locations of*p* bits determined to have low reliability. Reliability of bits may be determined or evaluated based on various criteria. For example, the reliability may be determined or evaluated based on an absolute value of an LLR generated from a signal received through a channel.

The LDPC code decoder may generate all 2*^{p}* possible bit patterns for *p* bits evaluated or identified to have low reliability, apply the generated bit patterns to LLRs, decode each resulting sequence, and combine decoding results to identify a final result. For example, when *p* = 3, all possible bit patterns are given as 2*^{p}* = 8 patterns, such as {000,001,010,011,100,101,110,111}, and one of the patterns corresponds to correct bits transmitted by a transmitter. Therefore, because one of eight possible bit patterns corresponds to actual bits transmitted by the transmitter, when all 8 possible bit patterns are applied to the LLRs and separately decoded, a sequence including actual bits transmitted by the transmitter may have a higher probability of iterative belief-propagation decoding as described below and thus actual bits transmitted by the transmitter may be identified by combining decoding results.

As an example of a method for reflecting each bit pattern in LLRs, an LLR having a maximum absolute value corresponding to a bit value may be assigned to a position of each bit. Based on Equation 3, an LLR having a maximum absolute value for bit 0 may be +∞, and in an actual implementation, the LLR having the maximum absolute value may be set to an arbitrary positive number in consideration of a representable LLR range and to avoid occurrence of various numerical problems. Based on Equation 3, an LLR having a maximum absolute value for bit 1 may be -∞, and in an actual implementation, the LLR having the maximum absolute value may be set to an arbitrary negative number in consideration of a representable LLR range and to avoid occurrence of various numerical problems.

The 2*^{p}*(= 8) modified candidate LLR sequences generated as described above are separately decoded. A decoding operation performing iterative message exchange, such as belief-propagation decoding, allows an LLR of each bit to affect updating of AP-LLRs of other bits. Therefore, among the 2*^{p}* modified candidate LLR sequences, a sequence including correct bits transmitted by a transmitter positively affects improvement of other bits through iterative belief-propagation decoding, thereby increasing a probability of successful decoding. Whether decoding succeeds may be identified based on an LDPC code and related functions. For example, decoding success may be verified through syndrome checking performed by an LDPC code decoder and decoding of an externally concatenated CRC code.

The above-described series of processes is a method in which all possible guesses for low-reliability bits are reflected in decoder inputs, and iterative belief-propagation decoding is expected to succeed for an input in which correct guesses are reflected. Such an opportunistic decoding operation may be referred to by various names. For example, it may be referred to as ensemble decoding, quasi maximum-likelihood (quasi-ML or QML) decoding, afterburner decoding, saturate decoding, or the like. In the description of an embodiment of the disclosure, such a technique will be referred to as ensemble decoding.

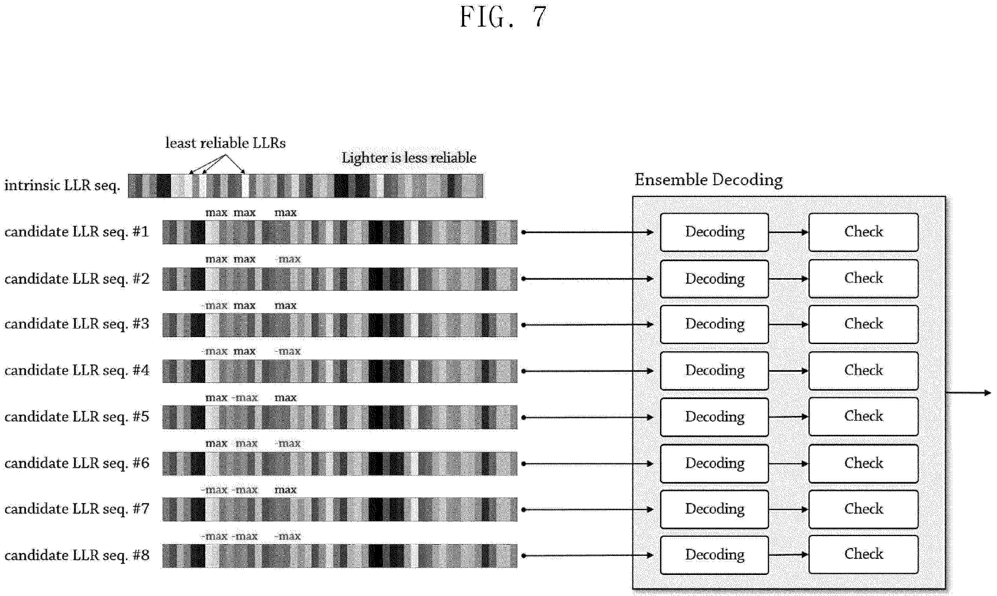

FIG. 7 illustrates an example of an ensemble decoding procedure to which various embodiments of the disclosure are applicable. Specifically, FIG. 7 conceptually illustrates a process of an ensemble decoding technique in which low-reliability LLRs are guessed in all possible manners in the above-described manner, and belief propagation is then performed to verify validity of decoding results. That is, FIG. 7 illustrates an ensemble decoding procedure in which a receiver selects positions of low-reliability LLRs in an intrinsic LLR sequence, generates modified candidate LLR sequences based thereon, and performs decoding.

With reference to FIG. 7, the ensemble decoding operation begins with a process of finding locations of *p* LLRs (p least reliable LLRs) having low absolute values (or determined to have low absolute values) in all or part of a given intrinsic LLR sequence. This process may involve a sorting process for absolute values over the entire range or a partial range of the given LLR sequence.

For example, if *N'* denotes the number of LLRs within a range in which values are to be changed (hereinafter, shortened to a search range) in an intrinsic LLR sequence, finding p LLRs having low absolute values within the search range involves ∑_{*k*=1,2,...,}*ₚ N'* - *k* comparison operations. Once p locations of LLRs having low absolute values are found in this manner, 2*^{p}* modified candidate LLR sequences are generated by modifying LLR values at the corresponding locations into preconfigured positive and negative values. The preconfigured positive and negative values may generally be determined as a maximum positive value and a minimum negative value used for LLR representation in the decoder, but are not limited thereto. For example, the preconfigured positive and negative values may be determined as arbitrary positive or negative values within a representable range. For example, as illustrated in FIG. 7, when p is 3, 8 modified candidate LLR sequences (candidate LLR seq. #1,...,#8) corresponding to all possible combinations may be generated. That is, 8 candidate LLR sequences may be generated by modifying three LLRs into {max, max, max}, {max, max, -max}, {-max, max, max}, {-max, max, -max}, {max, -max, max}, {max, -max, -max}, {-max, -max, max}, and {-max, -max, -max}. Here, max denotes the maximum positive value used for LLR representation in the above-described decoder.

As described above, the modified candidate LLR sequences may each be decoded independently. In the example of FIG. 7, eight modified candidate LLR sequences may each be independently decoded. As described above, decoding of an LDPC code is performed through a belief-propagation process based on an intrinsic LLR sequence. Because the modified candidate LLR sequences are generated for all possible combinations of codeword bits, one of the modified candidate LLR sequences clearly corresponds to correct codeword bits. Therefore, in a modified candidate LLR sequence in which LLR absolute values corresponding to the correct codeword bits are changed to maximum or high values, correct messages are delivered to other bits through an iterative message exchange decoding operation, thereby increasing a probability of successful decoding. Accordingly, after performing respective decodings based on the 2*^{p}* modified candidate LLR sequences, validity checks such as a syndrome check and a check using a concatenated CRC codes may be performed. If decoding is successfully completed, an estimate obtained through the corresponding decoding may be regarded as a final successful decoding result. In this manner, an ensemble decoding method and device improve a probability of successful decoding and error-correction performance by performing multiple decodings based on a plurality of modified candidate LLR sequences and aggregating decoding results.

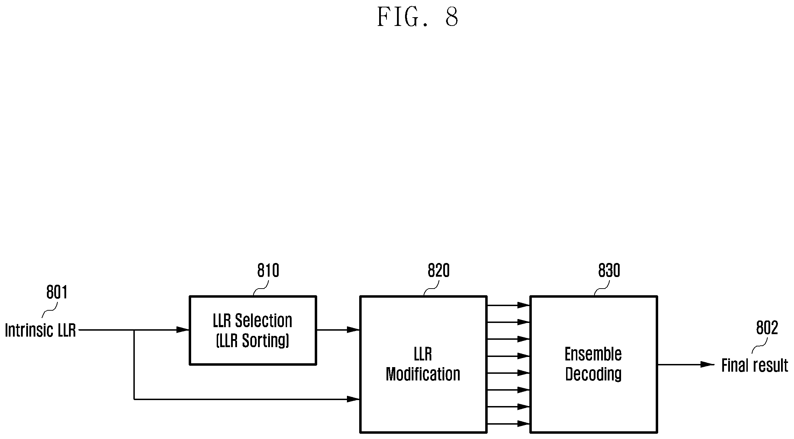

FIG. 8 is a block diagram illustrating an example of an operation sequence of ensemble decoding to which various embodiments of the disclosure are applicable.

With reference to FIG. 8, for a given intrinsic LLR sequence (801), an LLR selection process (810) for finding locations at which values of LLRs are to be changed is performed. For example, a process of sorting absolute values of LLRs and finding predetermined p locations having lower values may be used. Once the LLR locations to be changed are found, an LLR modification process (820) for generating up to 2*^{p}* modified candidate LLR sequences for all combinations of the corresponding locations is performed. A decoder decodes (830) each modified candidate LLR sequence and combines results thereof to generate a final result (802). For example, if any one of decodings performed based on the up to 2*^{p}* modified candidate LLR sequences succeeds, the decoder may output a corresponding result as the final result. Although a probability thereof is low, if two or more decodings succeed, the decoder may generate the final result according to a predetermined rule. If none of the decoding succeeds, the decoder may declare decoding failure.

Hereinafter, various embodiments of the disclosure provide a method for improving an ensemble decoding method and device.

According to conventional ensemble decoding methods and devices, independent decoding is performed for up to 2*^{p}* modified candidate LLR sequences. According to an embodiment of the disclosure, the following problems or improvable aspects in the conventional method are identified, and solutions and improvements for the problems may be provided.
- In conventional ensemble decoding methods and devices that perform independent decoding for up to 2*^{p}* modified candidate LLR sequences, hardware and software costs may increase. For example, in order to simultaneously perform decoding for the 2*^{p}* modified candidate LLR sequences at a specific time point, 2*^{p}* decoder constitutions may be required, which may lead to an increase in hardware and software costs. The hardware and software costs may include chip area, power consumption, arithmetic complexity, implementation complexity, and the like.
- In conventional ensemble decoding methods and devices, processing time and delay may increase when independent decoding is performed for up to 2*^{p}* modified candidate LLR sequences. For example, if decoding for the 2*^{p}* modified candidate LLR sequences is sequentially performed based on a single decoder (hardware, software, or a combination thereof), processing time and delay required to process the entire decoding may increase by up to 2*^{p}* times.

Various embodiments of the disclosure improve problems caused by conventional ensemble decoding methods and devices, such as increases in hardware and software costs, processing time, and delay, based on structures and characteristics of LDPC codes.

Various embodiments of the disclosure provide a device and method for efficiently decoding bits, symbols, signals, and the like, which are encoded with channel codes such as low-density parity-check (LDPC) codes and turbo codes and transmitted through a channel in a communication or broadcasting system.

Various embodiments of the disclosure provide a device and method for efficiently realizing and implementing ensemble decoding that determines a final result by decoding two or more modified LLR sequences generated by changing a value of at least one element in a log-likelihood ratio (LLR) sequence input to a decoder.

A decoding method and device according to various embodiments of the disclosure may effectively improve a utilization factor of a decoder for a reconfigurable LDPC code, thereby minimizing increases in hardware chip area, arithmetic complexity of hardware and software, implementation complexity, processing time, and latency.

According to a decoding method and device according to various embodiments of the disclosure, at least two modified decoder input sequences may be generated based on an original decoder input sequence, decoding may be performed based on each modified decoder input sequence, and results thereof may be combined to significantly improve decoding performance.

Typically, in order to decode two or more modified decoder input sequences, the same number of decoders may need to be configured, or a single decoder may need to operate the same number of times. However, the decoding method and device according to various embodiments of the disclosure may combine at least two modified decoder input sequences into a single decoder input sequence and process the same using a single decoder. Accordingly, even when decoding for two or more decoder inputs is performed, the decoding method and device according to various embodiments of the disclosure may require only hardware and software costs, complexity, delay, and the like required for a single decoding operation.

According to the decoding method and device according to various embodiments of the disclosure, decoding may be performed using a single decoder structure and architecture for two or more *P* decoder inputs, thereby achieving the same effect as using *P* decoders without requiring additional hardware and software costs. According to the decoding method and device according to various embodiments of the disclosure, by performing only one decoding operation for two or more decoder inputs, the same effect as performing *P* decoding operations may be achieved without causing additional complexity and delay.

Hereinafter, various embodiments of the disclosure will be described. The various embodiments of the disclosure described below are not independent from each other, and one or more embodiments may be applied simultaneously or in combination.

In the disclosure, embodiments are described using terms employed in some communication standards (e.g., long term evolution (LTE), new radio (NR) defined by the 3rd generation partnership project (3GPP)), but this is merely for illustrative purposes. Embodiments of the disclosure may be easily modified and applied to other communication systems. That is, the disclosure is not limited to a 5G communication system or an LTE communication system, but may also be applied to 6G and subsequent communication systems.

In the following description of the disclosure, a reconfigurable LDPC code decoder is an example of a decoder to which the disclosure is applicable, and the disclosure may also be applied to decoders having other constitutions.

An ensemble decoding method and device according to an embodiment of the disclosure may simultaneously process at least two modified LLR sequences using a single decoder. The ensemble decoding method and device according to an embodiment of the disclosure may be designed based on a specific structure of an LDPC code being used.

For example, 5G NR LDPC codes may be designed to have a quasi-cyclic structure for efficient constitution and parallel operation of an encoder and a decoder. A class of LDPC codes designed to have such a structure is referred to as QC-LDPC codes. Hereinafter, embodiments of the disclosure will be described based on structures and characteristics of such QC-LDPC codes. This is merely exemplary, and various embodiments of the disclosure are not limited to systems using QC-LDPC codes, but may also be applied to other LDPC codes. For example, embodiments of the disclosure may be easily modified and applied to various systems using structures of LDPC codes similar to QC-LDPC codes (e.g., vector LDPC codes and the like).

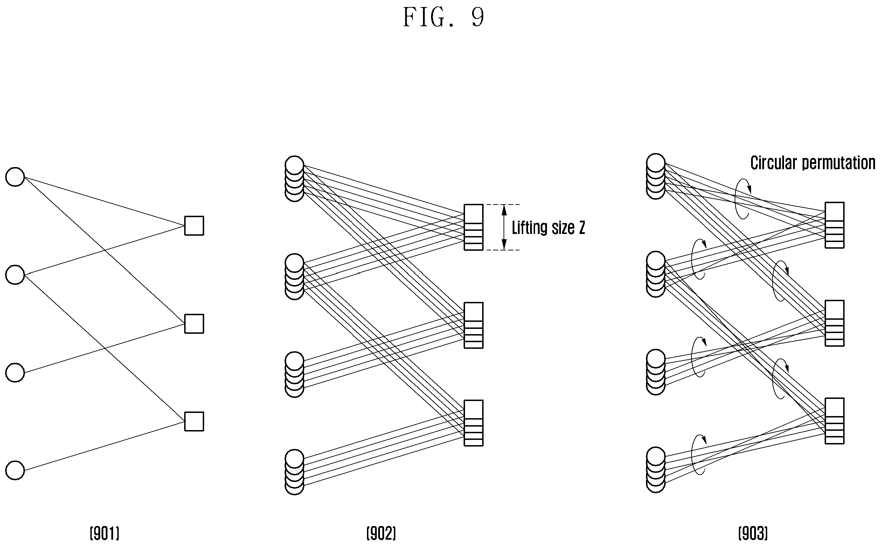

FIG. 9 illustrates an example of a process for constructing a QC-LDPC code to which various embodiments of the disclosure are applicable.

QC-LDPC codes are characterized in that a final LDPC code structure is generated from a small template code or graph referred to as a base graph (BG), a base matrix, a protograph, a proto-matrix, or the like. In the following description of various embodiments of the disclosure, the small template code or graph will be referred to as a protograph.

901 in FIG. 9 represents an example of a protograph. A process of constructing a QC-LDPC code based on the protograph begins by copying the protograph at least once, as illustrated in 902 in FIG. 9. The number of times the protograph is copied may be referred to as a lifting size and be expressed by a mathematical symbol *Z*.

When the protograph is copied as illustrated in 902 of FIG. 9, Z independent small graphs that are not connected to each other are generated. A next process is to circularly permute each edge bundle. Through this process, the Z small graphs may be connected to form one large graph. The one large graph generated through this process becomes a final bipartite graph of the QC-LDPC code. As illustrated by the relationship between FIGS. 3 and 4, the bipartite graph may be represented by a corresponding parity-check matrix having the same meaning.

The code dimensions and code length of the QC-LDPC code configured as described above may be adjusted by changing the lifting size Z (i.e., the number of copies of the protograph). By adjusting the lifting size, target code dimensions and code lengths may be achieved. Due to such characteristics, QC-LDPC codes are used in various systems, such as mobile communication systems, requiring flexible adjustment of code dimensions and code lengths. For example, in a 5G NR LDPC code system, the lifting size may be changed to a total of 51 values ranging from 2 to 384, and various code dimensions and code lengths may be supported.

The lifting size of the QC-LDPC code configured as described above is also closely related to a parallelization level of a decoder. As previously described with respect to a decoding operation of an LDPC code, belief-propagation decoding of the LDPC code is performed through an iterative message exchange process between VNs and CNs. Nodes such as VNs and CNs may be composed of individual components or units. Each node receives a message calculated from a connected neighboring node. A decoder for decoding the QC-LDPC code may be configured such that Z nodes within each group, also referred to as a QC block, are simultaneously processed, that is, processed in parallel. Therefore, the lifting size Z may also indicate a parallelization level that the decoder for the QC-LDPC code may simultaneously process.

Decoders for decoding QC-LDPC codes designed to support various lifting sizes, such as a 5G NR LDPC code system, may be implemented in various forms and manners. An example of a method for configuring a reconfigurable decoder supporting a lifting size Z that changes over time is to configure hardware and/or software based on a largest lifting size Zₘₐₓ used in the system and allow only some components to operate according to an actual lifting size applied at each time point.

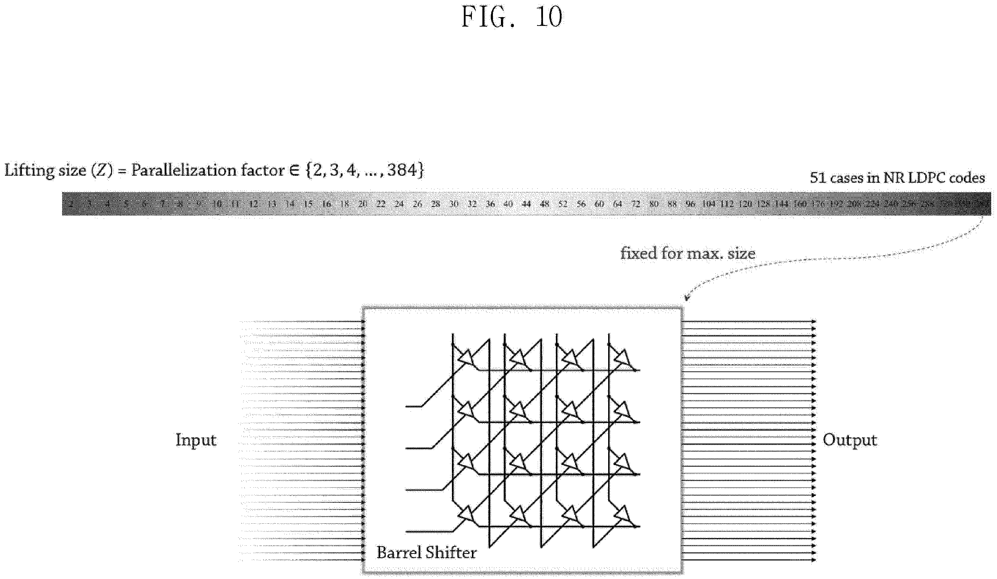

FIG. 10 illustrates an example of a constitution of a reconfigurable LDPC code decoder to which various embodiments of the disclosure are applicable.

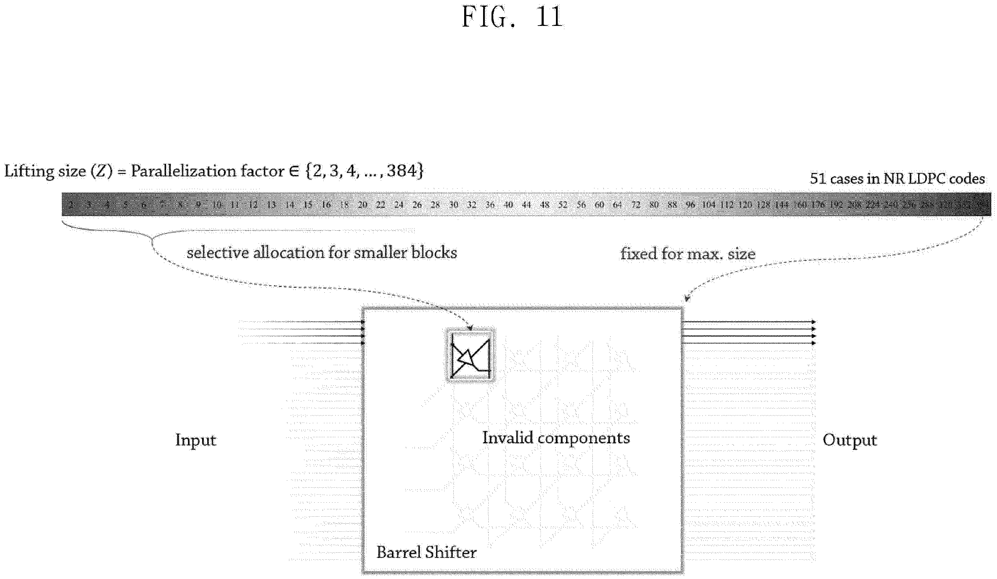

FIG. 11 illustrates an example of an operation in which a reconfigurable LDPC code decoder, to which various embodiments of the disclosure are applicable, decodes an LDPC code having a lifting size smaller than a maximum lifting size.

FIGS. 10 and 11 illustrate examples of reconfigurable decoder constitution operations for a 5G NR LDPC code system.

In a 5G NR LDPC code system, a lifting size *Z* may have a total of 51 values ranging from 2 to 384. Therefore, a maximum lifting size *Z*ₘₐₓ supported by the 5G NR LDPC code system may be 384. The decoder may be designed to support a circular permutation structure of a QC-LDPC code. The circular permutation structure of the QC-LDPC code may include, but is not limited to, a Benes network, a Banyan network, a QC-LDPC shifting network, a Barrel shifter network, and the like. FIGS. 10 and 11 illustrate an example in which the decoder is configured based on a Barrel shifter. A constitution of such a decoder, a size of the network, and the like may be determined based on the maximum lifting size *Z*ₘₐₓ = 384 supported by the system.

FIG. 10 conceptually illustrates an example of a constitution and operation of a decoder when a lifting size *Z* of the QC-LDPC code being used is a maximum size *Z*ₘₐₓ = 384. A decoder configured based on the maximum lifting size *Z*ₘₐₓ may perform decoding by using all components.

FIG. 11 conceptually illustrates an example of a constitution and operation of a decoder when a lifting size *Z* of a QC-LDPC code being used is smaller than a maximum size *Z*ₘₐₓ = 384. A decoder configured based on the maximum lifting size *Z*ₘₐₓ may operate only some components to decode the QC-LDPC code having an actual lifting size *Z*. In this case, according to implementation and constitution of hardware and software, components that do not need to operate may be controlled not to actually operate. Conversely, according to implementation and constitution of hardware and software, components that do not need to operate may operate in the same manner based on, for example, a dummy input, but results thereof may not ultimately be used. That is, a QC-LDPC code for actual decoding may be input to some components of the decoder, and a dummy input may be input to the remaining components. From an obtained output, a result corresponding to the dummy input may be excluded, and a decoding result may be determined based on a result corresponding to the QC-LDPC code for actual decoding. A method for processing components that do not need to operate may be determined and designed based on characteristics, requirements, priorities, and the like of hardware and software being used.

A decoder for a reconfigurable LDPC code configured based on the maximum lifting size *Z*ₘₐₓ may operate only some components according to the lifting size *Z* of a code being used. Components that do not need to operate may not actually operate or may operate based on a dummy input; however, as a result, hardware or software corresponding to components that do not need to operate does not contribute to generating a final result (i.e., a decoding result), as described above. Components that do not contribute to generating the final result in this manner are referred to as components that do not operate effectively, or simply invalid components.

Various embodiments of the disclosure relate to a method for increasing a hardware and software utilization factor by additionally utilizing invalid components that do not need to operate when performing decoding for a lifting size *Z* that changes over time in a reconfigurable LDPC code decoder configured based on a maximum lifting size *Z*ₘₐₓ, and for achieving only a complexity, processing time, and delay required for a single decoding operation even when multiple decoding operations are performed.

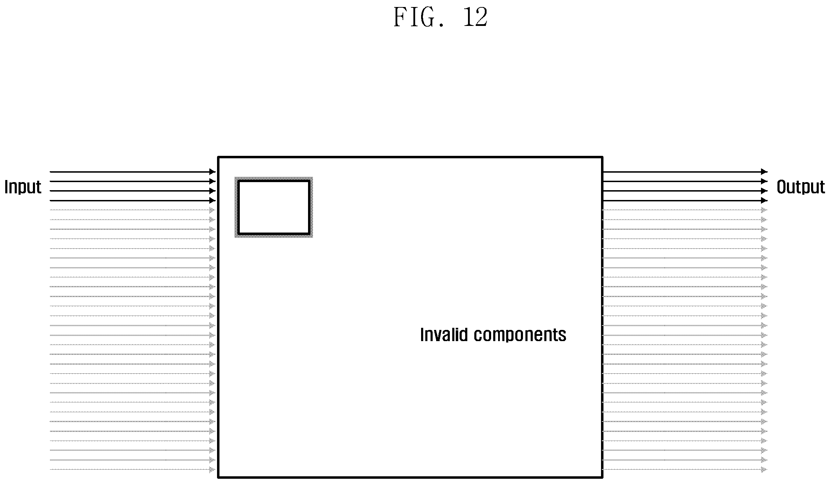

FIG. 12 illustrates an example of an invalid component when a reconfigurable LDPC code decoder, to which various embodiments of the disclosure are applicable, decodes an LDPC code having a lifting size smaller than a maximum lifting size.

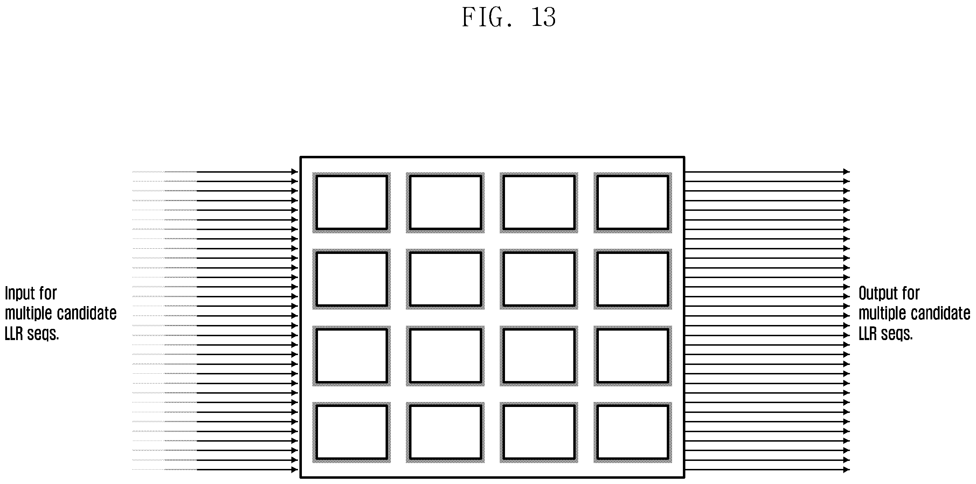

FIG. 13 illustrates an example in which a reconfigurable LDPC code decoder decodes inputs for at least two LDPC codes having a lifting size smaller than a maximum lifting size according to an ensemble decoding method, according to various embodiments of the disclosure.

FIG. 12 conceptually illustrates an example of a conventional reconfigurable LDPC code decoder, and FIG. 13 conceptually illustrates an example of using a reconfigurable LDPC code decoder according to various embodiments of the disclosure.

With reference to FIG. 12, when a conventional reconfigurable LDPC code decoder decodes an LDPC code having a lifting size*Z* smaller than a maximum lifting size *Z*ₘₐₓ, only some of all components are used, and the remaining components become invalid components. Accordingly, inefficiency in hardware and software utilization may increase.

However, according to various embodiments of the disclosure, a method and device for decoding an LDPC code may additionally utilize invalid components that are not utilized in a conventional scheme when performing ensemble decoding. Modified candidate LLR sequences generated for ensemble decoding may all correspond to the same LDPC code and be processed by the same decoder. In other words, *P* = 2*^{p}* modified candidate LLR sequences generated by changing *p* LLR values of an original LLR sequence according to all possible patterns for ensemble decoding may all correspond to LDPC codes having the same code dimension and code length. That is, the modified candidate LLR sequences may have the same code configurations. Therefore, the*P* modified candidate LLR sequences may be processed by a decoder for the same LDPC code configuration. Based on this, as illustrated in FIG. 13, an ensemble decoder of LDPC codes configured according to various embodiments of the disclosure may receive, as input, at least two modified candidate LLR sequences equal to or less than *P*, and process the received modified candidate LLR sequences to generate outputs corresponding to the same number (i.e., the number of input candidate LLR sequences).

According to various embodiments of the disclosure, the at least two modified candidate LLR sequences may be combined to generate or obtain an input sequence to be input to an LDPC code decoder. For example, the at least two modified candidate LLR sequences may be appropriately combined according to a constitution of the LDPC code decoder. Such a process of generating one (or seemingly one) sequence or vector based on at least two sequences or vectors may be regarded as multiplexing.

For example, it may be considered that four modified candidate LLR sequences are processed by a single reconfigurable ensemble decoder.

For example, the four modified candidate LLR sequences may be concatenated in order and multiplexed.

For example, the four modified candidate LLR sequences may be multiplexed in a manner in which elements respectively included in the four modified candidate LLR sequences are sequentially selected one by one. The selected elements may be multiplexed such that the selected elements are arranged in the selected order to generate a single sequence. For example, a single sequence may be generated by arranging elements in the following order: a first-1 element selected from a first candidate sequence, a second-1 element selected from a second candidate sequence, a thrid-1 element selected from a third candidate sequence, a fourth-1 element selected from a fourth candidate sequence, a first-2 element selected from the first candidate sequence, a second-2 element selected from the second candidate sequence, and so on.

For example, the four modified candidate LLR sequences may be multiplexed into a single sequence by performing interleaving on each sequence.

The multiplexing may be in a form suitable for the reconfigurable LDPC decoder being used and may not necessarily be in a single unique form. The multiplexing method may vary according to the LDPC decoder.

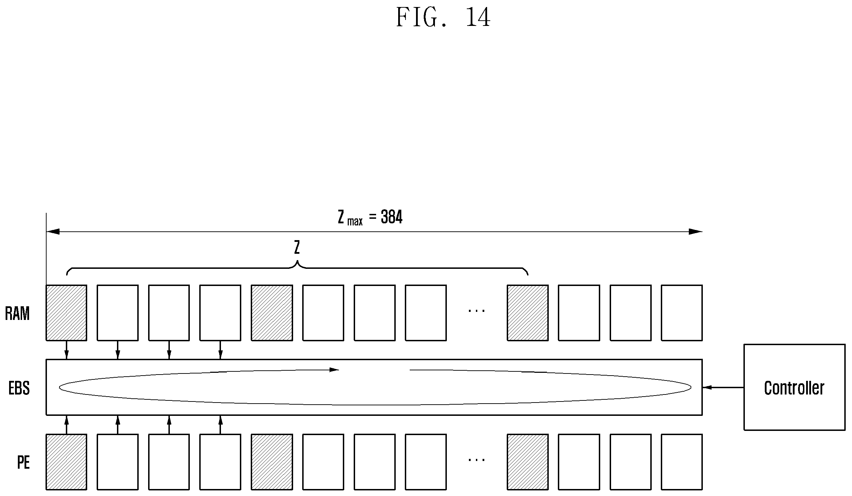

FIG. 14 illustrates an example of an operation of a reconfigurable LDPC code decoder implemented based on an extended barrel shifter (EBS), to which various embodiments of the disclosure are applicable.

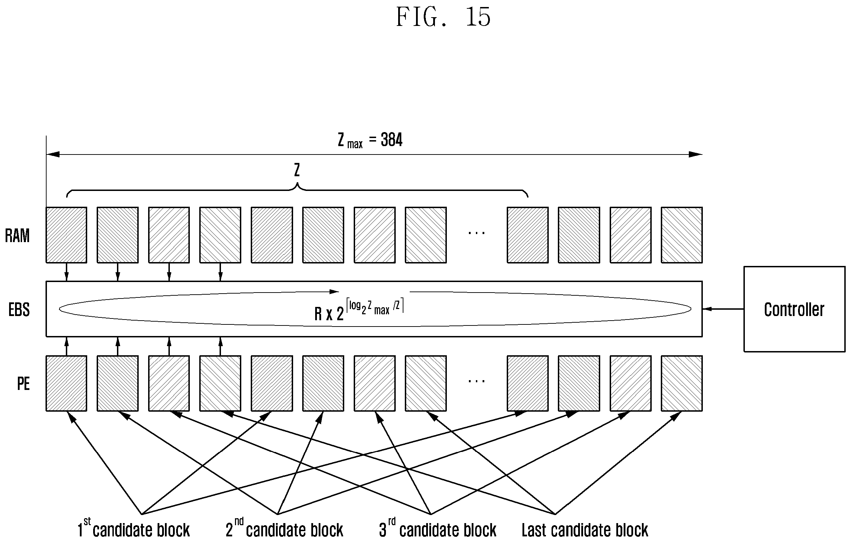

FIG. 15 illustrates an example in which an ensemble decoding method according to various embodiments of the disclosure is applied based on an operation of a reconfigurable LDPC code decoder implemented based on an EBS.

With reference to FIGS. 14 and 15, an example of a method for performing ensemble decoding according to various embodiments of the disclosure will be described based on an EBS-based reconfigurable LDPC decoder. The EBS-based reconfigurable LDPC decoder is provided as an example, and the disclosure is not limited thereto. For example, various embodiments of the disclosure may be applied to an LDPC decoder in which each element of an input LLR sequence is uniformly distributed or allocated for processing.

With reference to FIG. 14, when an EBS-based reconfigurable LDPC decoder (or controller) decodes an LDPC code having a lifting size *Z* smaller than a maximum lifting size *Z*ₘₐₓ (e.g., 384), the decoder may process each element of an input LLR sequence by uniformly distributing or allocating the element. Each element of the input LLR sequence may be distributed or allocated in a memory (e.g., a random access memory (RAM)) or a processing unit (PU) or a processing element (PE). A memory or a processing unit in which elements of the input LLR sequence are not placed may become an invalid component that does not have a value or contain a dummy value. Because QC-LDPC codes are constructed by cyclic permutations, elements may be processed by cyclically shifting by a given permutation shift value across all components. The decoder may identify a valid value among the processed values and output the valid value as a result.

FIG. 15 conceptually illustrates a method for decoding an LDPC code for at least two modified candidate LLR sequences having a lifting size *Z* smaller than a maximum lifting size *Z*ₘₐₓ using an EBS-based reconfigurable LDPC decoder according to various embodiments of the disclosure.

With reference to FIG. 15, the EBS-based LDPC code decoder according to various embodiments of the disclosure may be implemented based on a method of uniformly placing each element of an input LLR sequence.

According to various embodiments of the disclosure, each element of at least two modified candidate LLR sequences may be uniformly placed or allocated in a non-overlapping manner, as illustrated in FIG. 15. In FIG. 15, R may denote a predefined shift value, and operations may be performed based thereon.

For example, FIG. 15 illustrates a case in which four candidate sequences are used. A first element of a first candidate LLR sequence (1st candidate block), a first element of a second candidate LLR sequence (2nd candidate block), a first element of a third candidate LLR sequence (3rd candidate block), and a first element of a last candidate LLR sequence (last candidate block) may be sequentially placed or allocated in a PE and/or a RAM. Subsequently, a second element of the first candidate LLR sequence (1st candidate block), a second element of the second candidate LLR sequence (2nd candidate block), a second element of the third candidate LLR sequence (3rd candidate block), and a second element of the last candidate LLR sequence (last candidate block) may be sequentially placed or allocated in the PE and/or the RAM. In this manner, each element of the candidate sequences may be cyclically, permutatively, sequentially placed or allocated in a region corresponding to a maximum lifting size *Z*ₘₐₓ. That is, each element of the candidate sequences may be discontinuously placed or allocated in the region corresponding to the maximum lifting size *Z*ₘₐₓ.

As described above, in ensemble decoding, all modified candidate LLR sequences should be decoded by the same LDPC code. A cyclic permutation operation performed by an EBS-based LDPC decoder may ensure that the same operation (i.e., the same cyclic permutation operation) is applied to all modified candidate LLR sequences. Therefore, according to the method of the above embodiment of the disclosure, two or more modified candidate LLR sequences may be processed simultaneously based on a single hardware structure.

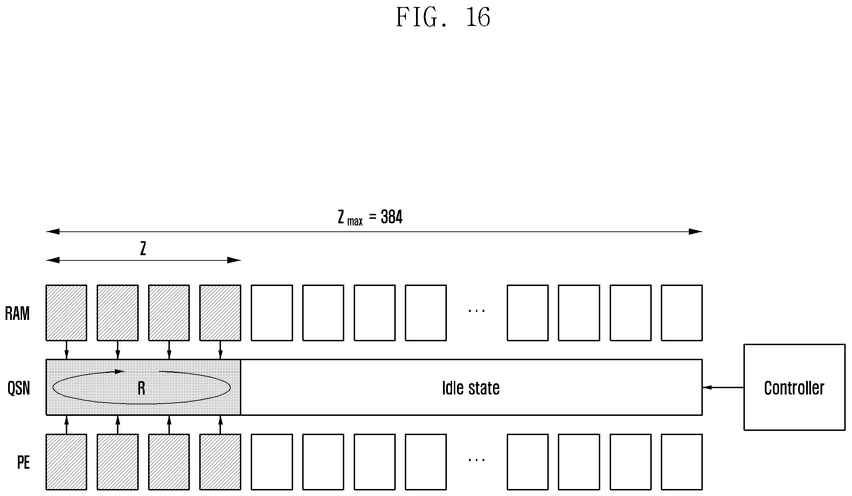

FIG. 16 illustrates an example of an operation of a reconfigurable LDPC code decoder implemented based on a QC-LDPC shifter network (QSN), to which various embodiments of the disclosure are applicable.

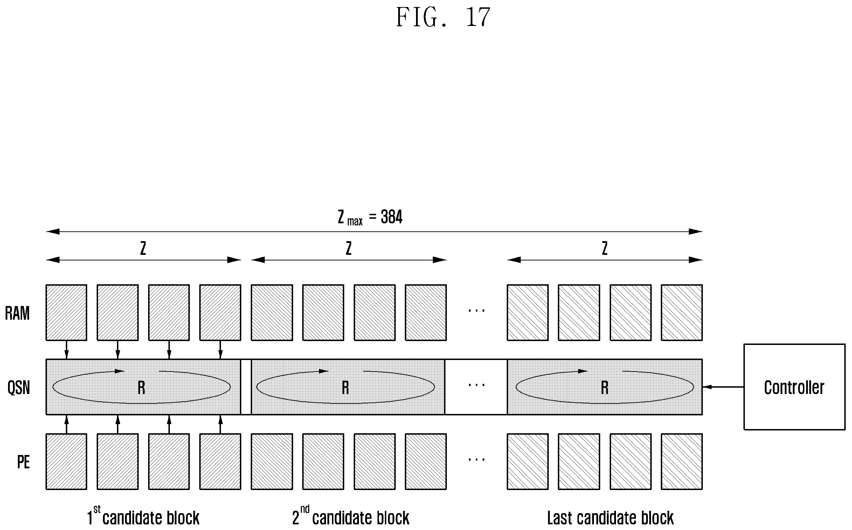

FIG. 17 illustrates an example in which an ensemble decoding method according to various embodiments of the disclosure is applied based on an operation of a reconfigurable LDPC code decoder implemented based on a QSN.

With reference to FIGS. 16 and 17, an example of a method for performing ensemble decoding according to various embodiments of the disclosure will be described based on a QSN-based reconfigurable LDPC decoder. The QSN-based reconfigurable LDPC decoder is provided as an example, and the disclosure is not limited thereto. For example, various embodiments of the disclosure may be applied to an LDPC decoder in which each element of an input LLR sequence is continuously distributed or allocated for processing.

With reference to FIG. 16, when a QSN-based reconfigurable LDPC decoder decodes an LDPC code having a lifting size *Z* smaller than a maximum lifting size *Z*ₘₐₓ (e.g., 384), the decoder processes each element of an input LLR sequence by placing the element in a designated contiguous region. Each element of the input LLR sequence may be placed or allocated in a memory (e.g., a random access memory (RAM)) or a processing unit (PU) or a processing element (PE) corresponding to the designated contiguous region. A memory or a processing unit in which elements of the input LLR sequence are not placed may become an invalid component that has no value or contains a dummy value, and may correspond to an idle state. Because QC-LDPC codes are constructed by cyclic permutations, elements such as LLRs assigned to the designated contiguous region may be processed by cyclically shifting by a given permutation shift value. The decoder may identify a valid value among processed values and output the valid value as a result.

FIG. 17 conceptually illustrates a method for decoding an LDPC code for at least two modified candidate LLR sequences having a lifting size *Z* smaller than a maximum lifting size *Z*ₘₐₓ using a QSN-based reconfigurable LDPC decoder according to an embodiment of the disclosure.

With reference to FIG. 17, a QSN-based LDPC code decoder according to various embodiments of the disclosure may be implemented based on placing each element of an input LLR sequence in a designated contiguous region.

According to various embodiments of the disclosure, each element of at least two modified candidate LLR sequences may be placed or allocated in respective non-overlapping regions, as illustrated in FIG. 17. In FIG. 17, R may denote a predefined shift value, and operations may be performed based thereon.

For example, FIG. 17 illustrates a case in which a single candidate sequence includes four elements. The first, second, third, and fourth elements of a first candidate LLR sequence (1st candidate block) may be sequentially placed or allocated in a PE and/or a RAM. Subsequently, the first, second, third, and fourth elements of a second candidate LLR sequence (2nd candidate block) may be sequentially placed or allocated in the PE and/or the RAM. In this manner, the first, second, third, and fourth elements of a last candidate LLR sequence (last candidate block) may be sequentially placed or allocated in the PE and/or the RAM. That is, each candidate sequence may be consecutively placed or allocated within a region corresponding to a maximum lifting size *Z*ₘₐₓ, and a region in which each candidate sequence is placed or allocated may correspond to a lifting size *Z*. Further, elements of each candidate sequence may be consecutively placed or allocated within a region corresponding to the lifting size *Z*.

As described above, in ensemble decoding, all modified candidate LLR sequences should be decoded by the same LDPC code. A QSN-based LDPC decoder may apply the same cyclic permutation operation to each region. Therefore, according to a method of the above embodiment of the disclosure, two or more modified candidate LLR sequences may be processed simultaneously based on a single hardware structure.

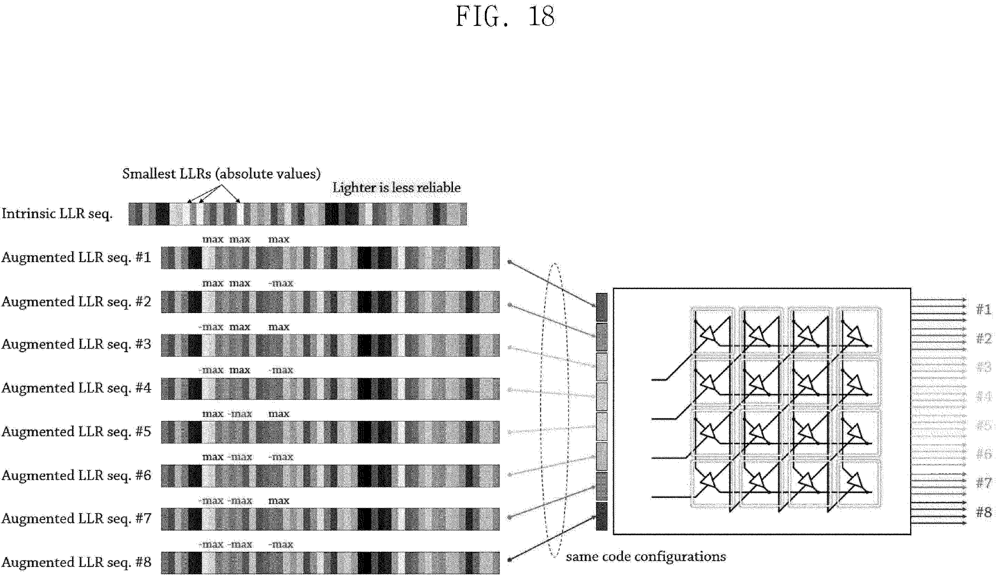

FIG. 18 is a conceptual diagram illustrating operations according to various embodiments of the disclosure. Operations according to various embodiments of the disclosure will be described with reference to an example of an ensemble decoding procedure described with reference to FIG. 7.

With reference to FIG. 18, according to an embodiment, 2*^{p}* modified candidate LLR sequences may be generated from a given intrinsic LLR sequence. For example, as illustrated in FIG. 18, when is 3, 8 modified candidate LLR sequences (candidate LLR seq. #1,...,#8) corresponding to all possible combinations may be generated. That is, 8 candidate LLR sequences may be generated or obtained by modifying 3 LLRs into {max, max, max}, {max, max, -max}, {-max, max, max}, {-max, max, -max}, {max, -max, max}, {max, -max, -max}, {-max, -max, max}, and {-max, -max, -max}. Here, max denotes a maximum positive value used for LLR representation in the above-described decoder.

According to an embodiment, a single input sequence may be generated or obtained based on multiplexing of modified candidate LLR sequences. That is, the modified candidate LLR sequences have the same code configurations and may be processed by the same decoder. Therefore, a single input sequence in which the modified candidate LLR sequences are multiplexed may be processed by a single decoder. The single input sequence is input to the decoder, and an output of the decoder may include decoding results (#1, #2,..., #8) corresponding to the modified candidate LLR sequences. As described above, because the modified candidate LLR sequences are generated based on all possible combinations of codeword bits, one of them corresponds to the correct codeword bit. Therefore, decoding results corresponding to the 2*^{p}* modified candidate LLR sequences may be obtained based on a single sequence in which the 2*^{p}* modified candidate LLR sequences are combined, and a validity check (i.e., a validity check for each of the decoding results) may be performed to obtain a final decoding result.

An ensemble decoding method and device according to various embodiments of the disclosure may determine the number p of LLRs to be changed and a maximum number *P* = 2*^{p}* of modified candidate LLR sequences based on a maximum lifting size **Zₘₐₓ** and an actual lifting size Z that can be processed by a decoder of a reconfigurable LDPC code. Alternatively, the number p of LLRs to be changed and the maximum number *P* = 2*^{p}* of modified candidate LLR sequences may be determined based on the maximum lifting size ***Z*ₘₐₓ,** the actual lifting size Z, and a number of operations of the decoder of the reconfigurable LDPC code. Because the relationship *P* = 2*^{p}*, when one of the number of LLRs to be changed or the maximum number of modified candidate LLR sequences is determined based on the maximum lifting size ***Z*ₘₐₓ** and the actual lifting size ***Z*** (or based on the maximum lifting size **Zₘₐₓ,** the actual lifting size ***Z***, and the number of operations of the decoder of the reconfigurable LDPC code), the other may also be determined according to the relationship *P* = 2*^{p}*. Herein and in the following description of various embodiments of the disclosure, the maximum number of modified candidate LLR sequences may refer to the number of candidate LLR sequences described in the above embodiment of the disclosure, and the number of candidate LLR sequences described in the above embodiment of the disclosure may be replaced with the maximum number of modified candidate LLR sequences. According to an embodiment of the disclosure, a receiving device may perform operations based on the maximum number of modified candidate LLR sequences or a number less than or equal thereto.

For example, when all modified candidate LLR sequences are to be processed by operating a decoder of a reconfigurable LDPC code, which is designed to process a maximum lifting size ***Z*ₘₐₓ** = **384,** in a single operation, the number *p* of LLRs to be changed and the maximum number *P* = 2*^{p}* of modified candidate LLR sequences may be determined according to the actual lifting size ***Z,*** as shown in Table 1.

**[Table 1: Configurations according to lifting size Z of a reconfigurable ensemble decoder based on a maximum lifting size Zₘₐₓ = 384 (assuming a single decoding operation)]**

| Lifting size | Number of modified candidate LLR sequences | Number of LLRs to change value |
|---|---|---|
| *Z* | *P* = 2*^{p}* | *p* |
| 12 or less | 32 (= 384/12) | 5 |
| greater than 12 and less than or equal to 24 | 16 (= 384/24) | 4 |
| greater than 24 and less than or equal to 48 | 8 (= 384/48) | 3 |
| greater than 48 and less than or equal to 96 | 4 (= 384/96) | 2 |
| greater than 96 and less than or equal to 192 | 2 (= 384/192) | 1 |
| greater than 192 | 1 | 0 |

As another example, when all modified candidate LLR sequences are to be processed by operating a decoder of a reconfigurable LDPC code designed to process a maximum lifting size ***Z*ₘₐₓ** = 192 in a single operation, the number *p* of LLRs to be changed and the maximum number *P =* 2*^{p}* of modified candidate LLR sequences may be determined according to the actual lifting size *Z* (*Z* ≤ 192), as shown in Table 2.

**[Table 2: Configurations according to a lifting size Z of a reconfigurable ensemble decoder based on a maximum lifting size Zₘₐₓ = 192 (assuming a single decoding operation)]**

| Lifting size | Number of modified candidate LLR sequences | Number of LLRs to change value |
|---|---|---|
| *Z* | *P* = 2*^{p}* | *p* |
| 12 or less | 16 (= 192/12) | 4 |
| greater than 12 and less than or equal to 24 | 8 (= 192/24) | 3 |
| greater than 24 and less than or equal to 48 | 4 (= 192/48) | 2 |
| greater than 48 and less than or equal to 96 | 2 (= 192/96) | 1 |
| greater than 96 | 1 | 0 |

As another example, when all modified candidate LLR sequences are to be processed by operating a decoder of a reconfigurable LDPC code designed to process a maximum lifting size ***Z*ₘₐₓ** = **384** in two operations, the number *p* of LLRs to be changed and the maximum number *P =* 2*^{p}* of modified candidate LLR sequences may be determined according to the actual lifting size *Z,* as shown in Table 3.

**[Table 3: Configurations according to a lifting size Z of a reconfigurable ensemble decoder based on a maximum lifting size Zₘₐₓ = 384 (assuming two decoding operations)]**

| Lifting size | Number of modified candidate LLR sequences | Number of LLRs to change value |
|---|---|---|
| *Z* | *P* = 2*^{p}* | *p* |
| 12 or less | 64 (= 384/12 * 2) | 6 |
| greater than 12 and less than or equal to 24 | 32 (= 384/24 * 2) | 5 |
| greater than 24 and less than or equal to 48 | 16 (= 384/48 * 2) | 4 |
| greater than 48 and less than or equal to 96 | 8 (= 384/96 * 2) | 3 |
| greater than 96 and less than or equal to 192 | 4 (= 384/192 * 2) | 2 |
| greater than 192 | 2 (= 384/384 * 2) | 1 |

The contents of Tables 1, 2, and 3 may be summarized as shown in Equation 13.$p = log \left(\left⌊{Z}_{max}/Z\right⌋\times Q\right) and P = {2}^{p}$

In Equation 13, *Z*ₘₐₓ denotes a maximum lifting size that can be processed by a reconfigurable LDPC code decoder, and may be a maximum lifting size defined by a communication system and standard, or may be smaller than the maximum lifting size. Further, *Z* denotes a lifting size of an LDPC code to be decoded. *Q* denotes a number of operations of the reconfigurable LDPC code decoder. Tables 1, 2, and 3 may all be summarized in a generalized form by Equation 13.

P may be understood as satisfying Equation 14.$P = {2}^{log \left(\left⌊{Z}_{max}/Z\right⌋\times Q\right)}$

If the number of operations of the reconfigurable LDPC code decoder is assumed to be 1 (*Q* = 1), Equation 13 may be transformed into Equation 15 and Equation 14 may be transformed into Equation 16.$p = log \left(\left⌊{Z}_{max}/Z\right⌋\right) and P = {2}^{p}$$P = {2}^{log \left(\left⌊{Z}_{max}/Z\right⌋\right)}$

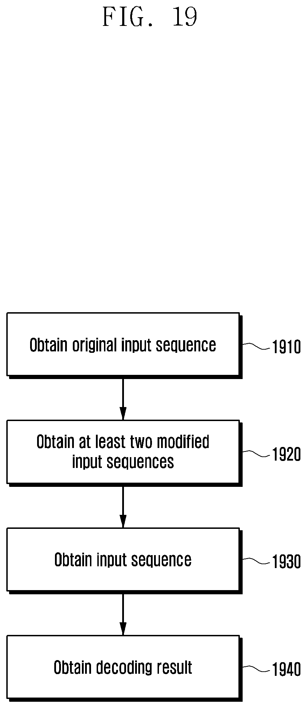

FIG. 19 is a flowchart illustrating an example of an operation of a device according to various embodiments of the disclosure. Various modifications may be made to the method illustrated in FIG. 19. For example, although illustrated as a series of steps, the various steps illustrated in the drawing may overlap, be performed in parallel, be performed in a different order, or be performed multiple times. In other examples, one or more steps may be omitted or replaced with other steps.

With reference to FIG. 19, in operation 1910 according to an embodiment, the device may obtain an original input sequence based on a received signal. For example, the received signal may be encoded according to a specific channel code (e.g., an LDPC code). For example, the original input sequence may be replaced with, but is not limited to, an original input vector, an original input array, and the like. For example, the original input sequence may be, but is not limited to, a log-likelihood ratio (LLR) sequence.

In operation 1920 according to an embodiment, the device may obtain P candidate input sequences (or modified input sequences) based on the original input sequence. According to an embodiment, P may be 2 or more. According to an embodiment, each of the P candidate input sequences may be a sequence in which at least one of elements included in the original input sequence is changed to a predefined value.

In operation 1930 according to an embodiment, the device may obtain a single input sequence based on the P candidate input sequences.

In operation 1940 according to an embodiment, the device may obtain a decoding result corresponding to the received signal based on an output obtained from a single decoder to which the single input sequence is input. For example, the output may include decoding results for each of the P candidate input sequences, and a final decoding result may be determined or obtained based thereon.

Specific details of the operation of the device according to an embodiment of the disclosure may be understood with reference to the above description of an embodiment of the disclosure.

Methods according to the embodiments described in the claims or the specification of the disclosure may be implemented in the form of hardware, software, or a combination of hardware and software.

In the case of being implemented in software, a computer readable storage medium storing one or more programs (software modules) may be provided. One or more programs stored in the computer readable storage medium are configured for execution by one or more processors in an electronic device. The one or more programs include instructions for causing the electronic device to execute methods according to embodiments described in the claims or the specification of the disclosure.

Such programs (software modules, software) may be stored in a random access memory, a non-volatile memory including a flash memory, a read only memory (ROM), an electrically erasable programmable ROM (EEPROM), a magnetic disc storage device, a compact disc-ROM (CD-ROM), digital versatile discs (DVDs), any other form of optical storage device, or a magnetic cassette. Alternatively, the programs may be stored in a memory composed of a combination of some or all thereof. Further, each constitution memory may be included in the plural.

Further, the program may be stored in an attachable storage device that may access through a communication network such as the Internet, Intranet, local area network (LAN), wide LAN (WLAN), or storage area network (SAN), or a communication network composed of a combination thereof. Such a storage device may access a device implementing an embodiment of the disclosure through an external port. Further, a separate storage device on a communication network may access a device implementing the embodiment of the disclosure.

In the specific embodiments of the disclosure described above, components included in an embodiment are expressed in the singular or plural according to the presented specific embodiments. However, the singular or plural expression is appropriately selected for a situation presented for convenience of description, and the disclosure is not limited to the singular or plural components, and even if a component is represented in the plural, it may be composed of the singular, or even if a component is represented in the singular, it may be composed of the plural.

Embodiments of the disclosure disclosed in this specification and drawings merely present specific examples in order to easily describe the technical contents of the disclosure and help the understanding of the disclosure, and they are not intended to limit the scope of the disclosure. That is, it will be apparent to those of ordinary skill in the art to which the disclosure pertains that other modifications based on the technical spirit of the disclosure may be implemented. Further, each of the above embodiments may be operated in combination with each other, as needed.

In the drawings for describing the method of the disclosure, the order of description does not necessarily correspond to the order of execution, and the precedence relationship may be changed or may be executed in parallel.

Alternatively, the drawings illustrating a method of the disclosure may omit some components and include only some components within the scope that does not impair the essence of the disclosure.

Further, the method of the disclosure may be implemented in a combination of some or all of the contents included in each embodiment within the scope that does not impair the essence of the disclosure.

Various embodiments of the disclosure have been described above. The above description of the disclosure is for illustrative purposes, and the embodiments of the disclosure are not limited to the disclosed embodiments. A person skilled in the art to which the disclosure pertains will understand that the disclosure may be easily modified into another specific form without changing technical idea or essential features thereof. The scope of the disclosure is represented by the claims to be described later rather than the above detailed description, and all changes or modified forms derived from the meaning and scope of the claims and equivalent concepts thereof should be construed as being included in the scope of the disclosure.

## Claims

1. A method performed by a device, the method comprising:
obtaining an original input sequence based on a received signal;
obtaining P candidate input sequences based on the original input sequence, wherein P is 2 or more, and each of the P candidate input sequences is obtained by changing at least one of elements included in the original input sequence to a predefined value;
obtaining a single input sequence based on the P candidate input sequences; and
obtaining a decoding result corresponding to the received signal based on an output obtained by inputting the single input sequence to a single decoder.

2. The method of claim 1, wherein the single decoder is configured to decode a low-density parity-check (LDPC) code,
wherein a lifting size associated with the LDPC code is configured to one of a plurality of predefined lifting sizes,
wherein P is determined based on the configured lifting size and a maximum lifting size among the plurality of predefined lifting sizes, and
wherein the configured lifting size corresponds to a size of each of the P candidate input sequences.

3. The method of claim 2, wherein in case that the maximum lifting size is 384:
P is 32 in case that the configured lifting size is 12 or less,
P is 16 in case that the configured lifting size is greater than 12 and less than or equal to 24,
P is 8 in case that the configured lifting size is greater than 24 and less than or equal to 48,
P is 4 in case that the configured lifting size is greater than 48 and less than or equal to 96, and
P is 2 in case that the configured lifting size is greater than 96 and less than or equal to 192; and
wherein in case that the maximum lifting size is 192:
P is 16 in case that the configured lifting size is 12 or less,
P is 8 in case that the configured lifting size is greater than 12 and less than or equal to 24,
P is 4 in case that the configured lifting size is greater than 24 and less than or equal to 48, and
P is 2 in case that the configured lifting size is greater than 48 and less than or equal to 96.

4. The method of claim 2, wherein P is determined to satisfy $P = {2}^{log \left(\left⌊{Z}_{max}/Z\right⌋\right)}$ , where *Z*ₘₐₓ is the maximum lifting size, and *Z* is the configured lifting size.

5. The method of claim 1, wherein the at least one changed element includes p elements selected from among elements included in the original input sequence in ascending order of absolute value, and
wherein the P candidate input sequences are different sequences obtained by changing each of the p elements to a maximum positive number or a minimum negative number representable by the single decoder, and *P* = 2*^{p}* is satisfied.

6. The method of claim 1, wherein the output is a single output including decoding results of the P candidate input sequences, and the decoding result corresponding to the received signal corresponds to a decoding result of one candidate input sequence identified based on a validity check on the decoding results of the P candidate input sequences included in the single output.

7. The method of claim 1, wherein in case that the single decoder is configured to distribute elements included in the input sequence:
upon input of the single input sequence to the single decoder, elements included in any one of the P candidate input sequences included in the single input sequence are discontinuously allocated to at least one of a memory or a processing element (PE) corresponding to the single decoder within a region corresponding to the maximum lifting size,
wherein in case that the single decoder is configured to continuously allocate elements included in an input sequence,
upon input of the single input sequence to the single decoder, elements included in any one of the P candidate input sequences included in the single input sequence are continuously allocated to at least one of a memory or a PE corresponding to the single decoder within a region corresponding to the configured lifting size.

8. The method of claim 1, wherein the single input sequence is:
obtained by concatenating the P candidate input sequences,
obtained by sequentially selecting elements from each of the P candidate input sequences and sequentially arranging the selected elements, or
obtained by interleaving of the P candidate input sequences.

9. A device, comprising:
a transceiver; and
a processor connected to the transceiver, wherein the processor is configured to:
obtain an original input sequence based on a received signal;
obtain P candidate input sequences based on the original input sequence, wherein P is 2 or more, and each of the P candidate input sequences is obtained by changing at least one of elements included in the original input sequence to a predefined value;
obtain a single input sequence based on the P candidate input sequences; and
obtain a decoding result corresponding to the received signal based on an output obtained by inputting the single input sequence to a single decoder.

10. The device of claim 9, wherein the single decoder is configured to decode a low-density parity-check (LDPC) code,
wherein a lifting size associated with the LDPC code is configured to one of a plurality of predefined lifting sizes,
wherein P is determined based on the configured lifting size and a maximum lifting size among the plurality of predefined lifting sizes, and
wherein the configured lifting size corresponds to a size of each of the P candidate input sequences.

11. The device of claim 10, wherein in case that the maximum lifting size is 384:
P is 32 in case that the configured lifting size is 12 or less,
P is 16 in case that the configured lifting size is greater than 12 and less than or equal to 24,
P is 8 in case that the configured lifting size is greater than 24 and less than or equal to 48,
P is 4 in case that the configured lifting size is greater than 48 and less than or equal to 96, and
P is 2 in case that the configured lifting size is greater than 96 and less than or equal to 192; and
wherein in case that the maximum lifting size is 192:
P is 16 in case that the configured lifting size is 12 or less,
P is 8 in case that the configured lifting size is greater than 12 and less than or equal to 24,
P is 4 in case that the configured lifting size is greater than 24 and less than or equal to 48, and
P is 2 in case that the configured lifting size is greater than 48 and less than or equal to 96.

12. The device of claim 10, wherein P is determined to satisfy $P = {2}^{log \left(\left⌊{Z}_{max}/Z\right⌋\right)}$ , where *Z*ₘₐₓ is the maximum lifting size, and *Z* is the configured lifting size.

13. The device of claim 9, wherein the at least one modified element include p elements selected from among elements included in the original input sequence in ascending order of absolute value, and
wherein the P candidate input sequences are different sequences obtained by changing each of the p elements to a maximum positive number or a minimum negative number representable by the single decoder, and *P* = 2*^{p}* is satisfied.

14. The device of claim 9, wherein the output is a single output including decoding results of the P candidate input sequences, and the decoding result corresponding to the received signal corresponds to the decoding result of one candidate input sequence identified based on a validity check on decoding results of the P candidate input sequences included in the single output.

15. The device of claim 9, wherein in case that the single decoder is configured to distribute elements included in the input sequence:
upon input of the single input sequence to the single decoder, elements included in any one of the P candidate input sequences included in the single input sequence are discontinuously allocated to at least one of a memory or a processing element (PE) corresponding to the single decoder within a region corresponding to the maximum lifting size,
wherein in case that the single decoder is configured to continuously allocate elements included in an input sequence:
upon input of the single input sequence to the single decoder, elements included in any one of the P candidate input sequences included in the single input sequence are continuously allocated to at least one of a memory or a PE corresponding to the single decoder within a region corresponding to the configured lifting size, and
wherein the single input sequence is:
obtained by concatenating the P candidate input sequences,
obtained by sequentially selecting elements from each of the P candidate input sequences and sequentially arranging the selected elements, or
obtained by interleaving of the P candidate input sequences.
